# EUROPEAN PATENT APPLICATION

(11) **EP 4 521 162 A1**
(43) Date of publication of application: **12.03.2025**
(21) Application number: 23887998.5
(22) Date of filing: 07.11.2023
(51) Int. Cl.: G02F 1/1362, G02F 1/1343, H01L 33/00, H01L 29/00, H01L 21/77

(54) **ARRAY SUBSTRATE AND DISPLAY APPARATUS**

(30) Priority: 08.11.2022 CN 202211387912
(71) Applicant: Boe Technology Group Co., Ltd., Beijing 100015 (CN); Beijing BOE Technology Development Co., Ltd., Beijing 100176 (CN)
(72) Inventor: LONG, Chunping, Beijing 100176 (CN); MA, Yongda, Beijing 100176 (CN)
(74) Representative: Maiwald GmbH
(86) International application number: PCT/CN2023/130160
(87) International publication number: WO 2024/099309

(57) **Abstract**

Provided are an array substrate and a display apparatus. The array substrate comprises: a base substrate, which comprises a main surface; a transistor, which is located on the main surface of the base substrate, and comprises an active layer and a first electrode connected to the active layer; a first insulating layer, which is located between the base substrate and the active layer; a second insulating layer, which is located between the active layer and the first electrode; a pixel electrode, which is connected to the first electrode; and a common electrode, wherein the common electrode and the pixel electrode are insulated from each other, the pixel electrode and the common electrode are configured to form an electric field, and the first electrode is in contact with the surface of the active layer that faces away from the base substrate, and is in contact with a side face of the active layer. The array substrate and the display apparatus facilitate an increase in the contact area of a first electrode and a side face of an active layer, and facilitate an increase in the capacitance of a storage capacitor formed by means of the first electrode and another electrode, thereby solving the problem of a pixel voltage being kept unstable due to a reduction in the storage capacitor that is caused by a reduction in the pixel area.

## Description

### CROSS-REFERENCE TO RELATED APPLICATION

For all purposes, the patent application claims the priority of the Chinese patent application No. 202211387912.X filed on November 8, 2022, the entire disclosure of which is incorporated herein by reference as part of the present application.

### TECHNICAL FIELD

At least one embodiment of the present disclosure relates to an array substrate and a display device.

### BACKGROUND

The display devices currently widely used include thin film transistor-liquid crystal displays (TFT-LCD), and more and more displays are developing towards high resolution and high image quality, so as to provide users with a better user experience.

### SUMMARY

At least one embodiment of the present disclosure relates to an array substrate and a display device to increase the capacitance of a storage capacitor by setting a compensation capacitor.

At least one embodiment of the present disclosure provides an array substrate, including: a base substrate, including a main surface; a transistor, located on the main surface of the base substrate, and including an active layer and a first electrode connected with the active layer; a first insulating layer, located between the base substrate and the active layer; a second insulating layer, located between the active layer and the first electrode; a pixel electrode, connected with the first electrode; and a common electrode, insulated from the pixel electrode, the pixel electrode and the common electrode being configured to form an electric field; the first electrode is in contact with a surface of the active layer facing away from the base substrate, and is in contact with a side surface of the active layer.

For example, the array substrate further includes a first via hole, the first electrode is connected with the active layer through the first via hole, and the first via hole includes a first through hole penetrating the second insulating layer and a first groove located in the first insulating layer.

For example, a maximum dimension of the first groove in a plane parallel with the main surface is less than a minimum dimension of the first through hole in the plane parallel with the main surface.

For example, a maximum dimension of the first groove in a direction perpendicular to the main surface is less than a maximum dimension of the first through hole in the direction perpendicular to the main surface.

For example, the pixel electrode extends into the first via hole and is in contact with the first electrode at the first via hole.

For example, the pixel electrode and the first electrode are conformal at the first via hole, and a maximum dimension of a portion, in contact with the first electrode, of the pixel electrode in a direction perpendicular to the main surface is greater than or equal to a maximum dimension of the first via hole in the direction perpendicular to the main surface.

For example, the array substrate further includes: a third insulating layer, the third insulating layer is located on the first electrode, and the common electrode is located on the third insulating layer.

For example, the pixel electrode and the common electrode are conformal at the first via hole.

For example, the first insulating layer includes a first insulating portion and a second insulating portion, the first groove is located in the first insulating portion, and a thickness of the first insulating portion is greater than a thickness of the second insulating portion.

For example, the thickness of the first insulating portion is greater than twice the thickness of the second insulating portion.

For example, the array substrate further includes a light shielding layer, the light shielding layer is located between the active layer and the base substrate, an orthographic projection of the active layer on the base substrate falls within an orthographic projection of the light shielding layer on the base substrate, and the first electrode and the light shielding layer form a compensation capacitor.

For example, the light shielding layer is floating or the light shielding layer is electrically connected with the common electrode.

For example, a thickness of the first insulating layer is in a range from 50nm to 300nm.

For example, the pixel electrode and the common electrode form a main storage capacitor, and a ratio of a capacitance of the compensation capacitor to a capacitance of the main storage capacitor is greater than or equal to 0.2.

For example, the ratio of the capacitance of the compensation capacitor to the capacitance of the main storage capacitor is less than or equal to 0.8.

For example, the ratio of the capacitance of the compensation capacitor to the capacitance of the main storage capacitor is greater than or equal to 0.25 and less than or equal to 0.6

For example, at least one of the first electrode and the pixel electrode forms a first storage capacitor with the common electrode, and the first storage capacitor includes a first capacitor in a plane parallel with the main surface and a second capacitor in a direction perpendicular to the main surface.

For example, the pixel electrode and the common electrode form a main storage capacitor, and a ratio of a capacitance of the second capacitor to a capacitance of the main storage capacitor is greater than or equal to 0.02.

For example, the ratio of the capacitance of the second capacitor to the capacitance of the main storage capacitor is less than or equal to 0.2.

For example, the ratio of the capacitance of the second capacitor to the capacitance of the main storage capacitor is greater than or equal to 0.06 and less than or equal to 0.08.

For example, the array substrate further includes a third insulating layer and a fourth insulating layer, the third insulating layer is located on the first electrode, the common electrode is located on the third insulating layer, and the fourth insulating layer is located between the pixel electrode and the common electrode.

For example, the array substrate further includes a second via hole, the pixel electrode is connected with the first electrode through the second via hole, the second via hole includes a second through hole and a second groove, the second through hole penetrates the third insulating layer or penetrates the fourth insulating layer and the third insulating layer, and the second groove is located in the second insulating layer; and the pixel electrode is in contact with a surface of the first electrode facing away from the base substrate, and is in contact with a side surface of the first electrode.

For example, a maximum dimension of the second groove in a plane parallel with the main surface is less than a minimum dimension of the second through hole in the plane parallel with the main surface.

For example, a maximum dimension of the second groove in a direction perpendicular to the main surface is less than a maximum dimension of the second through hole in the direction perpendicular to the main surface.

For example, the common electrode is located between the first electrode and the pixel electrode, the common electrode and the first electrode form one first storage capacitor, and the common electrode and the pixel electrode form another first storage capacitor.

For example, the array substrate further includes a third insulating layer, a fourth insulating layer, and a second via hole, the third insulating layer is located on the first electrode, the fourth insulating layer is located between the pixel electrode and the common electrode, the pixel electrode is connected with the first electrode through the second via hole, and the second via hole includes a second through hole and a second groove, the second through hole penetrates the third insulating layer or penetrates the third insulating layer and the fourth insulating layer, and the second groove is located in the second insulating layer.

For example, the pixel electrode is in contact with a surface of the first electrode facing away from the base substrate, and is in contact with a side surface of the first electrode.

For example, the array substrate further includes a first via hole, the first electrode is connected with the active layer through the first via hole, the pixel electrode is in contact with a surface of the first electrode facing away from the base substrate, and an orthographic projection of the first via hole on the base substrate overlaps with an orthographic projection of the second via hole on the base substrate.

For example, the first via hole includes a first through hole penetrating the second insulating layer and a first groove located in the first insulating layer.

For example, the array substrate further includes a data line, the transistor further includes a second electrode, the second electrode is connected with the active layer, the data line is connected with the second electrode, and an orthographic projection of the pixel electrode on the base substrate overlaps with an orthographic projection of the data line on the base substrate.

For example, a width of a portion of the pixel electrode overlapping with the data line is less than 3 microns.

For example, the array substrate further includes a data line, the transistor further includes a second electrode, the second electrode is connected with the active layer, the data line is connected with the second electrode, one of the pixel electrode and the common electrode which is away from the base substrate has a slit, and an orthographic projection of the common electrode on the substrate overlaps with an orthographic projection of the data line on the base substrate.

For example, a width of a portion of the common electrode overlapping with the data line is less than 3 microns.

For example, an included angle between the data line and the slit is in a range from 1 degree to 20 degrees.

For example, a shape of the first via hole includes at least one of a circle, a rectangle, or a chamfered rectangle.

For example, the array substrate further includes a first protection structure, an orthographic projection of the first protection structure on the base substrate overlaps with an orthographic projection of the first via hole on the base substrate, a portion of the first protection structure is filled in a first recess of the array substrate at the first via hole, and a portion of the first protection structure protrudes from the first recess.

For example, the array substrate further includes a second protection structure, an orthographic projection of the second protection structure on the base substrate overlaps with an orthographic projection of the second via hole on the base substrate, a portion of the second protection structure is filled in a second recess of the array substrate at the second via hole, and a portion of the second protection structure protrudes from the second recess.

For example, the array substrate further includes a data line, the transistor further includes a second electrode, the second electrode is connected with the active layer, the data line is connected with the second electrode, the pixel electrode is located between the common electrode and the base substrate, and the common electrode has a slit.

For example, a distance between the pixel electrode and the slit includes at least two unequal distances at a same side of the slit.

For example, the array substrate further includes an electrode lead, the electrode lead is connected with the common electrode, and an orthographic projection of the electrode lead on the base substrate overlaps with an orthographic projection of the data line on the base substrate.

For example, the data line includes a plurality of inclined portions, a bending portion is arranged between adjacent inclined portions, an extension direction of the inclined portion is the same as an extension direction of the slit, and the first via hole has a chamfer, and an extension direction of an edge of the first via hole at the chamfer is the same as an extension direction of the bending portion.

For example, a distance between the edge of the first via hole at the chamfer and the bending portion is greater than or equal to 1 micron and less than or equal to 5 microns.

For example, the pixel electrode has a first portion and a second portion with different extension directions, an extension direction of the first portion is the same as an extension direction of the slit, and an edge of the first portion is parallel with an edge of the slit, and is parallel with an edge of the data line.

For example, an edge of the second portion is not parallel with the edge of the slit, and the edge of the second portion is parallel with the data line.

For example, a minimum distance between the edge of the second portion and the edge of the slit is less than 1 micron.

Embodiments of the present disclosure further provide an array substrate including: a base substrate, including a main surface; a transistor, located on the main surface of the base substrate, and including an active layer and a first electrode connected with the active layer; a first insulating layer, located between the base substrate and the active layer; a second insulating layer, located between the active layer and the first electrode; and a pixel electrode, connected with the first electrode; the pixel electrode is in contact with a surface of the first electrode facing away from the base substrate, and is in contact with a side surface of the first electrode.

Embodiments of the present disclosure further provide a display device, including any one of the array substrates as described above.

### BRIEF DESCRIPTION OF DRAWINGS

In order to clearly illustrate the technical solution of the embodiments of the present disclosure, the drawings of the embodiments will be briefly described in the following. It is obvious that the described drawings are only related to some embodiments of the present disclosure and thus are not limitative of the present disclosure.
Fig. 1A is a cross-sectional view of a display panel.
Fig. 1B is a plan view of a display panel.
Fig. 2 is a plan view of an array substrate provided by an embodiment of the present disclosure.
Fig. 3 is a cross-sectional view taken along line A1-A2 of Fig. 2.
Fig. 4A to Fig. 4H are single-layer views of the array substrate shown in Fig. 2.
Fig. 5 is a schematic diagram of a first capacitor in a first storage capacitor formed by a common electrode and a first electrode in an array substrate provided by an embodiment of the present disclosure.
Fig. 6 is a schematic diagram of a second capacitor in a first storage capacitor formed by a common electrode and a first electrode in an array substrate provided by an embodiment of the present disclosure.
Fig. 7 is an equivalent circuit diagram of an array substrate provided by an embodiment of the present disclosure.
Fig. 8 is a simplified schematic diagram of an array substrate provided by an embodiment of the present disclosure.
Fig. 9 is a schematic diagram of a common electrode in an array substrate provided by an embodiment of the present disclosure.
Fig. 10 is a cross-sectional view of an array substrate provided by an embodiment of the present disclosure.
Fig. 11 is an equivalent circuit diagram of the array substrate shown in Fig. 10.
Fig. 12 is a cross-sectional view of an array substrate provided by an embodiment of the present disclosure.
Fig. 13 is an equivalent circuit diagram of the array substrate shown in Fig. 12.
Fig. 14 is a plan view of an array substrate provided by an embodiment of the present disclosure.
Fig. 15 is a cross-sectional view taken along line A3-A4 of Fig. 14.
Fig. 16A is a plan view of an array substrate provided by an embodiment of the present disclosure.
Fig. 16B is a plan view of an array substrate provided by an embodiment of the present disclosure.
Fig. 17 is a cross-sectional view taken along line A5-A6 of Fig. 16A.
Fig. 18 is a plan view of an array substrate provided by an embodiment of the present disclosure.
Fig. 19 is a plan view of an array substrate provided by an embodiment of the present disclosure.
Fig. 20 is a cross-sectional view of an array substrate provided by an embodiment of the present disclosure.
Fig. 21 is a plan view of an array substrate provided by an embodiment of the present disclosure.
Fig. 22 is a cross-sectional view of an array substrate provided by an embodiment of the present disclosure.
Fig. 23 is a cross-sectional view of an array substrate provided by an embodiment of the present disclosure.
Fig. 24 is a cross-sectional view of an array substrate provided by an embodiment of the present disclosure.
Fig. 25 is a cross-sectional view of another array substrate provided by an embodiment of the present disclosure.
Fig. 26 is a plan view of an array substrate provided by an embodiment of the present disclosure.
Fig. 27 is a plan view of an array substrate provided by an embodiment of the present disclosure.
Fig. 28 is a cross-sectional view of an array substrate provided by an embodiment of the present disclosure.
Fig. 29 is a cross-sectional view of an array substrate provided by an embodiment of the present disclosure.
Fig. 30 is a cross-sectional view of an array substrate provided by an embodiment of the present disclosure.
Fig. 31 is a cross-sectional view of an array substrate provided by an embodiment of the present disclosure.
Fig. 32 is a cross-sectional view of an array substrate provided by an embodiment of the present disclosure.
Fig. 33 is a plan view of an array substrate provided by an embodiment of the present disclosure.
Fig. 34 is a plan view of an array substrate provided by an embodiment of the present disclosure.
Fig. 35 is a manufacturing flow chart of an array substrate provided by an embodiment of the present disclosure.

### DETAILED DESCRIPTION

For more clear understanding of the objectives, technical details and advantages of the embodiments of the present disclosure, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, the terms "comprise", "comprising", "include", "including", etc., are intended to specify that the elements or the objects stated before these terms encompass the elements or the objects and equivalents thereof listed after these terms, but do not preclude the other elements or objects. The phrases "connect", "connected" and the like are not limited to a physical or mechanical connection, but also include an electrical connection, either directly or indirectly. "On," "under," "right," "left" and the like are only used to indicate relative position relationship, and when the position of the described object is changed, the relative position relationship may be changed accordingly.

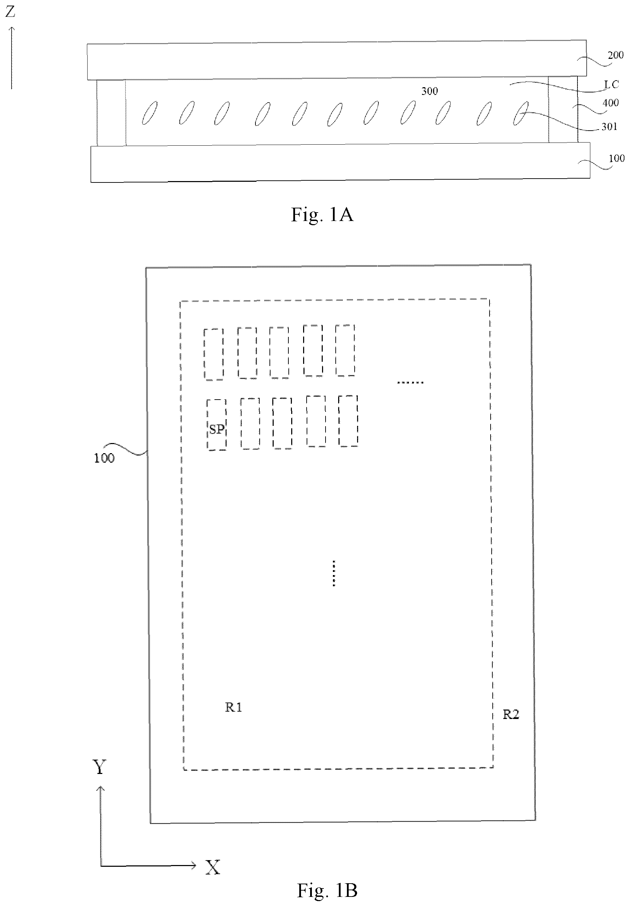

Fig. 1A is a cross-sectional view of a display panel. As shown in Fig. 1A, the display panel includes an array substrate 100 and an opposing substrate 200. The array substrate 100 and the opposing substrate 200 are arranged opposite to each other and are bonded by a frame sealant 400 to form a liquid crystal cell LC. A liquid crystal layer 300 is arranged in the liquid crystal cell LC, and the liquid crystal layer 300 includes a plurality of liquid crystal molecules 301. A pixel electrode and a common electrode can be disposed in the array substrate 100 to form a planar electric field that drives the liquid crystal molecules 301 to rotate.

Fig. 1B is a plan view of a display panel. Fig. 1B shows that the display panel includes a plurality of sub-pixels SP. The arrangement manner of the plurality of sub-pixels SP is not limited to that shown in Fig. 1B, and can be determined as needed. Fig. 1B shows a display region R1 and a peripheral region R2, the plurality of sub-pixels SP are located in the display region R1, and Fig. 1B takes that the peripheral region R2 surrounds the display region R1 as an example. The peripheral region R2 is located on at least one side of the display region R1.

In the accompanying drawings of the embodiment of the present disclosure, the direction X, the direction Y and the direction Z are three different directions, the direction X and the direction Y are directions parallel with the main surface of the array substrate 100 or the main surface of the opposing substrate 200, and the direction Z is a direction perpendicular to both the direction X and the direction Y. For example, the direction Z is the thickness direction of the array substrate 100 or the opposing substrate 200. The direction Z can also be the direction in which the array substrate 100 points to the opposing substrate 200. For example, the direction X intersects with the direction Y. The embodiment of the present disclosure is illustrated by taking that the direction X is perpendicular to the direction Y as an example.

As the display scanning frequency continues to increase, in the display panel, the pixel electrode and the common electrode overlap with each other to form a storage capacitor, and the non-overlapping portion of the pixel electrode and the common electrode forms an electric field to control the rotation of liquid crystal molecules, thereby controlling the display panel to display colorful images and videos.

As pixel density (Pixels Per Inch, PPI) continues to increase, the area of the pixel continues to decrease. In a high-PPI and high-definition display screen, the decrease of the pixel area results in the decrease of the storage capacitance, which further leads to the problem that the pixel voltage is hardly to be kept stable to affect the display quality.

Embodiments of the present disclosure provide an array substrate and a display device including the array substrate, to solve the problem that the display quality is affected by that the pixel voltage is hardly to be kept stable; and a compensation capacitor is provided to increase the storage capacitance, thereby improving the display quality.

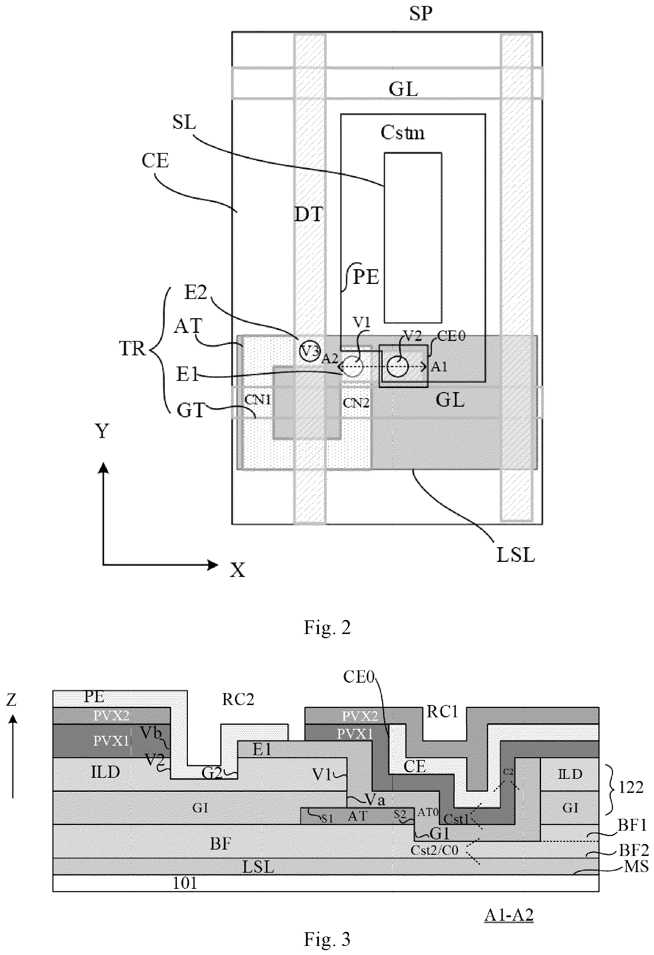

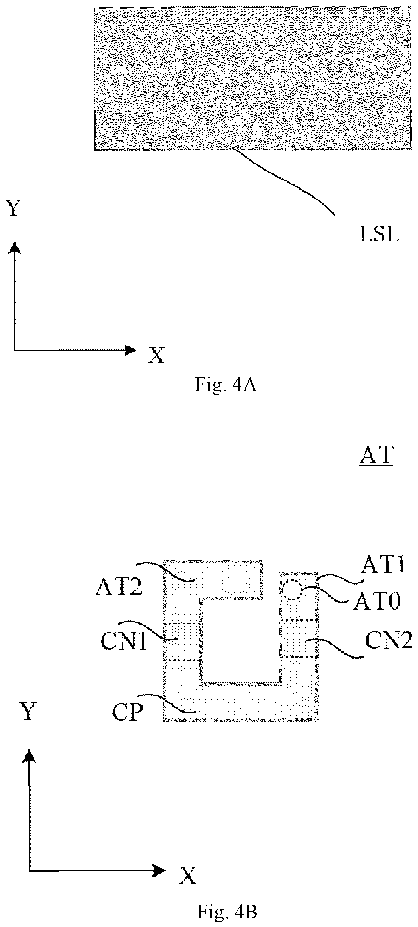

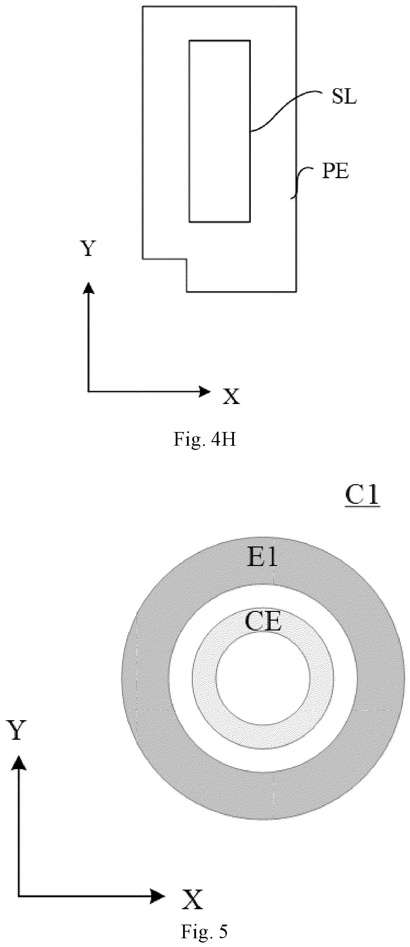

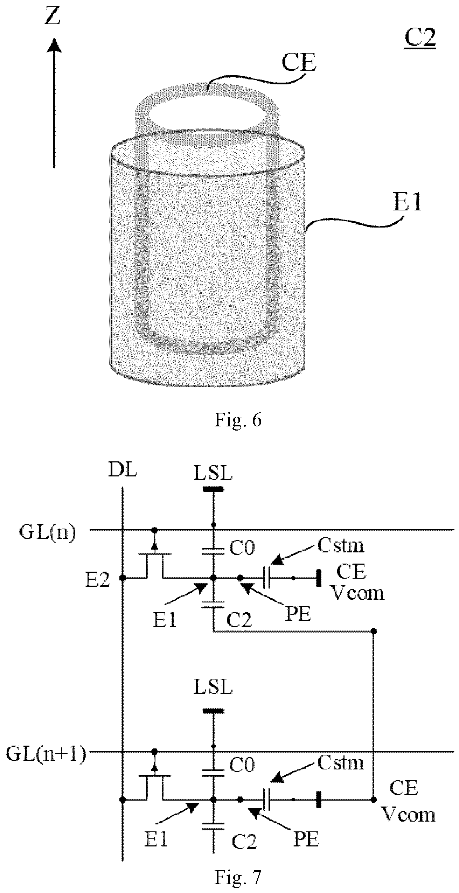

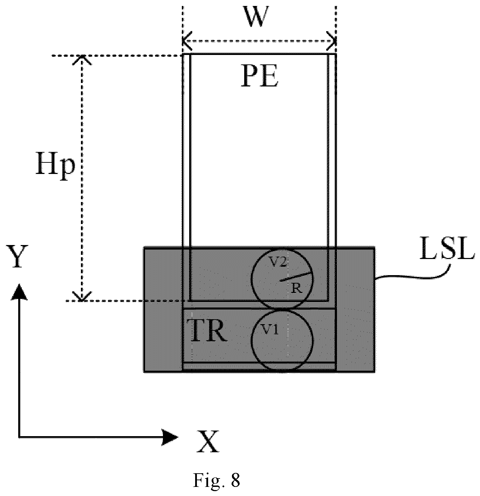

Fig. 2 is a plan view of an array substrate provided by an embodiment of the present disclosure. Fig. 3 is a cross-sectional view taken along line A1-A2 of Fig. 2. Fig. 4A to Fig. 4H are single-layer views of the array substrate shown in Fig. 2. Fig. 5 is a schematic diagram of a first capacitor in a first storage capacitor formed by a common electrode and a first electrode in an array substrate provided by an embodiment of the present disclosure. Fig. 6 is a schematic diagram of a second capacitor in a first storage capacitor formed by a common electrode and a first electrode in an array substrate provided by an embodiment of the present disclosure. Fig. 7 is an equivalent circuit diagram of an array substrate provided by an embodiment of the present disclosure. Fig. 8 is a simplified schematic diagram of an array substrate provided by an embodiment of the present disclosure.

As shown in Fig. 2 and Fig. 3, an embodiment of the present disclosure provides an array substrate, which includes a base substrate 101, a transistor TR, a first insulating layer BF, a second insulating layer 122, and a pixel electrode PE. As shown in Fig. 3, the base substrate 101 includes a main surface MS. As shown in Fig. 2 and Fig. 3, the transistor TR is located on the main surface MS of the base substrate 101, and includes an active layer AT and a first electrode E1 connected with the active layer AT. As shown in Fig. 3, the first insulating layer BF is located between the base substrate 101 and the active layer AT; the second insulating layer 122 is located between the active layer AT and the first electrode E1; and the pixel electrode PE is connected with the first electrode E1.

For example, as shown in Fig. 3, the first electrode E1 is in contact with the surface S1 of the active layer AT facing away from the base substrate 101, and is in contact with the side surface S2 of the active layer AT. As shown in Fig. 3, the second insulating layer 122 includes a gate insulating layer GI and an interlayer insulating layer ILD, but is not limited thereto. For example, the transistor TR includes a thin film transistor (TFT), but it is not limited thereto.

In the array substrate provided by the embodiment of the present disclosure, the first electrode E1 can be in contact with the surface S1 of the active layer AT facing away from the base substrate 101 and can be in contact with the side surface S2 of the active layer AT, which is helpful in increasing the contact area between the first electrode E1 and the side surface of the active layer AT, and cause the dimension of the first electrode E1 in the direction Z to be increased; and it is helpful in increasing the capacitance of a storage capacitor (compensation capacitor) formed by the first electrode E1 and another electrode (e.g., a common electrode CE) in the direction Z, and to form a storage capacitor (compensation capacitor) between the first electrode E1 and another electrode (e.g., a light shielding layer LSL), thus compensating for the storage capacitance. By designing the compensation capacitor, the array substrate provided by the embodiment of the present disclosure can solve the problem in the high PPI and high-definition display screen that the pixel voltage is hardly to be kept stable due to the decrease of the storage capacitor caused by the decrease of the pixel area.

As shown in Fig. 2 and Fig. 3, the array substrate further includes a common electrode CE, the common electrode CE is insulated from the pixel electrode PE, and the pixel electrode PE and the common electrode CE are configured to form an electric field. For example, the pixel electrode PE and the common electrode CE can form a planar electric field.

For example, the common electrode CE can be made of a transparent conductive material, and the pixel electrode PE can be made of a transparent conductive material. For example, the transparent conductive material includes indium tin oxide (ITO), but is not limited thereto. The embodiment of the present disclosure is illustrated by taking that both the pixel electrode PE and the common electrode CE are made of indium tin oxide as an example.

As shown in Fig. 3, Fig. 5 and Fig. 6, the first electrode E1 and the common electrode CE form a first storage capacitor Cst1, the first storage capacitor Cst1 includes a first capacitor C1 in a plane parallel with the main surface MS and a second capacitor C2 (compensation capacitor) in a direction perpendicular to the main surface MS, and the second capacitor C2 can also be called a sidewall capacitor. The first capacitor C1 is a planar capacitor.

In the embodiment of the present disclosure, the planar capacitor refers to that each of the two plates of the capacitor is parallel with the main surface MS of the base substrate 101. The sidewall capacitance refers to that each of the two plates of the capacitor is not parallel with the main surface MS of the base substrate 101.

As shown in Fig. 3 and Fig. 5 to Fig. 7, the compensation capacitor includes the second capacitor C2 in the first storage capacitor Cst1 and a storage capacitor C0, that is, the compensation capacitor includes the second capacitor C2 and the storage capacitor C0. As shown in Fig. 7, the common electrode CE is configured to be input with a common voltage Vcom. The storage capacitor C0 can also be called a compensation capacitor C0.

Because the pixel area of the high-PPI pixel is very small, the area of the storage capacitor formed by the pixel electrode and the common electrode is greatly reduced (for example, the area is reduced to one quarter or one eighth of the original area), so the capacitance of the storage capacitor can be compensated by setting a compensation capacitor (the second capacitor C2 and the storage capacitor C0).

For example, as shown in Fig. 2, Fig. 3 and Fig. 4A, the array substrate further includes a light shielding layer LSL, and the light shielding layer LSL is located between the active layer AT and the base substrate 101. The orthographic projection of the active layer AT on the base substrate 101 falls within the orthographic projection of the light shielding layer LSL on the base substrate 101, the first electrode E1 and the light shielding layer LSL form a storage capacitor C0 (compensation capacitor), and the storage capacitor C0 can also be called a second storage capacitor Cst2. For example, as shown in Fig. 2 and Fig. 3, the orthographic projection of the first electrode E1 on the base substrate 101 overlaps with the orthographic projection of the light shielding layer LSL on the base substrate 101. For example, as shown in Fig. 2 and Fig. 3, the orthographic projection of the first electrode E1 on the base substrate 101 falls within the orthographic projection of the light shielding layer LSL on the base substrate 101. For example, the light shielding layer LSL is floating or the light shielding layer LSL is electrically connected with the common electrode CE. On the one hand, the light shielding layer LSL plays a light shielding role to protect the active layer AT, and on the other hand, the light shielding layer LSL plays a role in forming a storage capacitor C0 with the first electrode E1 as a compensation capacitor.

For example, as shown in Fig. 3, in order to further increase capacitance of the storage capacitor C0 to play a better capacitance compensation role, the thickness of the first insulating portion BF1 is greater than the thickness of the second insulating portion BF2. For example, the thickness of the first insulating portion BF1 is 1.5-3.5 times the thickness of the second insulating portion BF2. For example, the thickness of the first insulating portion BF1 is greater than twice the thickness of the second insulating portion BF2.

In the embodiment of the present disclosure, the thickness of an element refers to the dimension of the element in the direction Z.

For example, in the array substrate provided by the embodiment of the present disclosure, by over-etching the first insulating layer BF, the depth of the first via hole V1 is increased, and the thickness of the dielectric layer (second insulating portion BF2) between the first electrode E1 and the light shielding layer LSL is reduced, which is helpful in increasing the capacitance of the compensation capacitor. In the array substrate provided by the embodiment of the present disclosure, the capacitance of the compensation capacitor is increased by reducing the thickness of the dielectric layer in the storage capacitor C0.

Referring to Fig. 3, in the array substrate provided by the embodiment of the present disclosure, the requirement of over-etching the first insulating layer BF can be independently satisfied without having to make the first electrode E1 in contact with the surface S1 of the active layer AT facing away from the base substrate 101 and in contact with the side surface S2 of the active layer AT; that is, as long as the over-etching of the first insulating layer BF is satisfied the thickness of the dielectric layer (second insulating portion BF2) between the first electrode E1 and the light shielding layer LSL is reduced, the capacitance of the storage capacitor C0 formed by the first electrode E1 and the light shielding layer LSL is increased.

For example, as shown in Fig. 2 and Fig. 3, the array substrate further includes a first via hole V1, the first electrode E1 is connected with the active layer AT through the first via hole V1, and the first via hole V1 includes a first through hole Va located in the second insulating layer 122 and a first groove G1 located in a portion of the first insulating layer BF close to the second insulating layer 122. As shown in Fig. 3, the first insulating layer BF is partially etched to form a half hole (groove). By partially etching the first insulating layer BF, the thickness of the dielectric layer between the first electrode E1 and the light shielding layer LSL is smaller, and the dimension of the first via hole V1 in the direction Z is increased.

As shown in Fig. 3, the first insulating layer BF includes a first insulating portion BF1 and a second insulating portion BF2. The first groove G1 penetrates the first insulating portion BF1, and the second insulating portion BF2 is a portion of the first insulating layer BF that is not penetrated.

For example, as shown in Fig. 3, in order to increase the storage capacitance, the maximum dimension of the first groove G1 in a plane parallel with the main surface MS is less than the minimum dimension of the first through hole Va in the plane parallel with the main surface MS.

For example, as shown in Fig. 3, in order to increase the storage capacitance, the maximum dimension of the first groove G1 in the direction perpendicular to the main surface MS is less than the maximum dimension of the first through hole Va in the direction perpendicular to the main surface MS.

For example, as shown in Fig. 3, in order to increase the storage capacitance, the array substrate further includes a second via hole V2, the pixel electrode PE is connected with the first electrode E1 through the second via hole V2, the second via hole includes a second through hole Vb and a second groove G2, the second through hole Vb penetrates the third insulating layer PVX1 or penetrates the fourth insulating layer PVX2 and the third insulating layer PVX1, and the second groove G2 is located in the second insulating layer 122; the second groove G2 is located in a portion of the second insulating layer 122 close to the third insulating layer PVX1; the pixel electrode PE is in contact with the surface of the first electrode E1 facing away from the base substrate 101, and is in contact with the side surface of the first electrode E1, so as to reduce the step difference, reduce the the probability of disconnection of the pixel electrode, and increase the contact area between the pixel electrode PE and the first electrode E1 to reduce the contact resistance.

For example, as shown in Fig. 3, in order to increase the storage capacitance, the maximum dimension of the second groove G2 in the plane parallel with the main surface MS is less than the minimum dimension of the second through hole Vb in the plane parallel with the main surface MS.

For example, as shown in Fig. 3, in order to increase the storage capacitance, the maximum dimension of the second groove G2 in the direction perpendicular to the main surface MS is less than the maximum dimension of the second through hole Vb in the direction perpendicular to the main surface MS.

For example, the maximum dimension of a through hole is the maximum dimension of a certain cross section of the through hole, and the cross section can be a cross section of the through hole in the maximum dimension or a cross section in other directions. For example, the minimum dimension of a through hole is the minimum dimension of a certain cross section of the through hole, and the cross section can be a cross section of the through hole in the minimum dimension or a cross section in other directions. For example, the through hole includes the first through hole Va or the second through hole Vb.

For example, the maximum dimension of a groove is the maximum dimension of a certain cross section of the groove, and the cross section can be a cross section of the groove in the maximum dimension or a cross section in other directions. For example, the minimum dimension of a groove is the minimum dimension of a certain cross section of the groove, and the cross section can be a cross section of the groove in the minimum dimension or a cross section in other directions. For example, the groove includes the first groove G1 or the second groove G2.

As shown in Fig. 3, the array substrate further includes a third insulating layer PVX1, the third insulating layer PVX1 is located on the first electrode E1; and the common electrode CE is located on the third insulating layer PVX1. In the sub-pixel SP, the common electrode CE and the pixel electrode PE may form a main storage capacitor Cstm.

Fig. 4A is a plan view of a light shielding layer in the array substrate shown in Fig. 2. Fig. 2, Fig. 3 and Fig. 4A show a light shielding layer LSL. For example, the light shielding layer LSL is floating or the light shielding layer LSL is electrically connected with the common electrode CE. On the one hand, the light shielding layer LSL plays a light shielding role to protect the active layer AT, and on the other hand, the light shielding layer LSL plays a role in forming a storage capacitor C0 with the first electrode E1 as a compensation capacitor.

For example, the light-shielding layer LSL is made of a conductive material, and the material of the light-shielding layer LSL includes metal to play a light shielding role.

Fig. 3 shows a first recess RC1 of the array substrate at the first via hole V1 and a second recess RC2 of the array substrate at the second via hole V2.

Fig. 4B is a plan view of an active layer in the array substrate shown in Fig. 2. For example, as shown in Fig. 2, Fig. 3 and Fig. 4B, the active layer AT may be in the form of a rectangular ring with a notched corner, so as to facilitate the formation of double channels; and Fig. 2 and Fig. 4B show a first channel CN1 and a second channel CN2, so that the transistor TR is formed into a double-gate structure. As shown in Fig. 2 and Fig. 4B, the active layer AT further includes a connection portion CP connecting the first channel CN1 and the second channel CN2, a first connection region AT1 connected with the first electrode E1, and a second connection region AT2 connected with the second electrode E2. In the active layer AT, the first channel CN1 and the second channel CN2 are formed of a semiconductor material, and the connection portion CP, the first connection region AT1, and the second connection region AT2 are all conductors formed by doping the semiconductor material. For example, the semiconductor material includes poly-silicon or oxide semiconductor material, but is not limited thereto.

Fig. 4B shows a hollow structure AT0 in the active layer AT. As shown in Fig. 3 and Fig. 4B, the orthographic projection of the hollow structure AT0 on the base substrate 101 falls within the orthographic projection of the first via hole V1 on the base substrate 101, and the dimension of the hollow structure AT0 is less than the dimension of the first via hole V1. In the case where the first via hole V1 and the hollow structure AT0 are both circular, the diameter of the hollow structure AT0 is less than the diameter of the first via hole V1. The setting position of the hollow structure AT0 is not limited to that shown in the figure, but can be determined as needed.

As shown in Fig. 3 and Fig. 4B, the orthographic projection of the hollow structure AT0 on the base substrate 101 falls within the orthographic projection of the light shielding layer LSL on the base substrate 101.

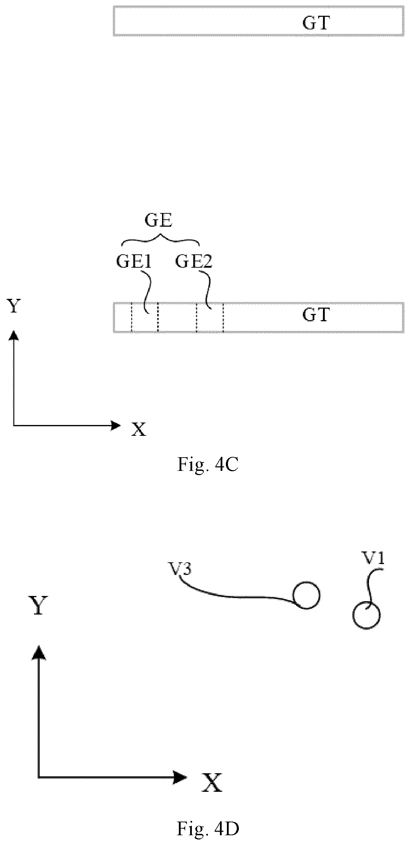

Fig. 4C is a plan view of a gate electrode and a gate line in the array substrate shown in Fig. 2. As shown in Fig. 2 and Fig. 4C, the gate electrode GE includes a first gate electrode GE1 and a second gate electrode GE2, the first gate electrode GE1 and the second gate electrode GE2 overlap with the first channel CN1 and the second channel CN2 respectively in the direction perpendicular to the base substrate 101. As shown in Fig. 4C, the gate electrode GE and the gate line GL are of an integral structure. As shown in Fig. 4C, the gate electrode GE is a portion of the gate line GL.

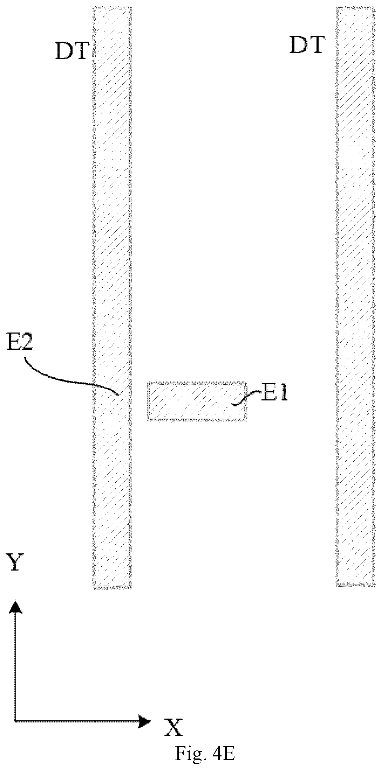

Fig. 4D is a plan view of a first via hole and a third via hole in the array substrate shown in Fig. 2. Fig. 4E is a plan view of a data line, a first electrode and a second via hole in the array substrate shown in Fig. 2.

As shown in Fig. 2, Fig. 4D and Fig. 4E, the first electrode E1 is connected with the active layer AT through a first via hole V1. As shown in Fig. 2, Fig. 4B, Fig. 4D and Fig. 4E, the first electrode E1 is connected with the first connection region AT1 of the active layer AT through the first via hole V1. As shown in Fig. 2, Fig. 4D and Fig. 4E, the second electrode E2 is connected with the active layer AT through a third via hole V3. As shown in Fig. 2, Fig. 4B, Fig. 4D and Fig. 4E, the second electrode E2 is connected with the second connection region AT2 of the active layer AT through the third via hole V3. The array substrate shown in Fig. 2 is described by taking that the first electrode E1 and the data line DL are located in the same layer as an example, but it is not limited to this case. In other embodiments, the first electrode E1 may not be located in the same layer as the data line DL, but is located in the same layer as the gate line GL.

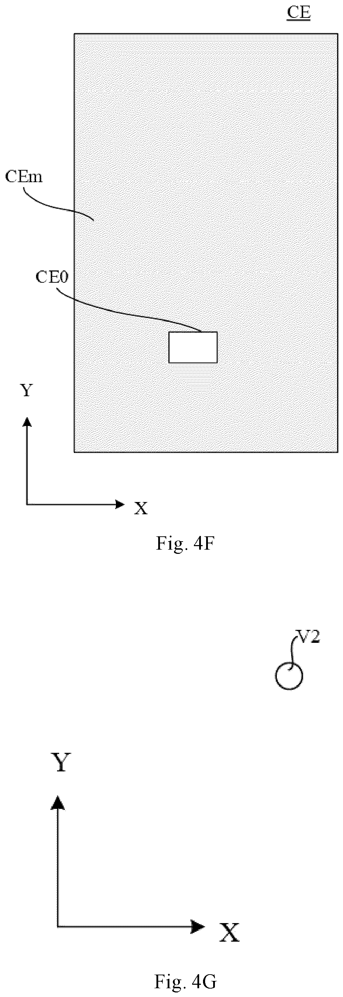

Fig. 4F is a plan view of a common electrode in the array substrate shown in Fig. 2. Fig. 4F shows a common electrode CE. As shown in Fig. 4F, the common electrode CE has a main portion CEm, and the main portion CEm and the pixel electrode PE form a storage capacitor (main storage capacitor Cstm).

As shown in Fig. 2 and Fig. 4F, the common electrode CE has a hollow structure CF0 to facilitate the connection between the pixel electrode PE and the first electrode E1.

Fig. 4G is a plan view of a second via hole in the array substrate shown in Fig. 2.

Fig. 4H is a plan view of a pixel electrode in the array substrate shown in Fig. 2. As shown in Fig. 2 and Fig. 4H, the pixel electrode PE has a slit SL, and the pixel electrode PE and the common electrode CE form an electric field.

As shown in Fig. 2, Fig. 3, Fig. 4E, Fig. 4F, Fig. 4G and Fig. 4H, the pixel electrode PE is connected with the first electrode E1 through the second via hole V2 and the hollow structure CF0. As shown in Fig. 2 and Fig. 3, the orthographic projection of the second via hole V2 on the base substrate 101 falls within the orthographic projection of the hollow structure CF0 on the base substrate 101.

In the array substrate provided by the embodiment of the present disclosure, the capacitance of the storage capacitor of the sub-pixel can be increased by setting at least one of the storage capacitor C0 and the second capacitor C2. The main storage capacitor Cstm formed between the common electrode CE and the pixel electrode PE can be called a planar capacitor which is a capacitor formed by electrodes in the planes parallel with the base substrate.

As shown in Fig. 2, Fig. 3 and Fig. 8, the capacitance of the main storage capacitor is Cstm = ε_{PVX2}*W*H/(4πk*THK_{PVX2}), where ε_{PVX2} is the dielectric constant of the fourth insulating layer PVX2; W is the width of the pixel electrode PE, that is, the dimension of the pixel electrode PE in the direction X; H is the length of the pixel electrode PE, that is, the dimension of the pixel electrode PE in the direction Y; THK_{PVX2} is the thickness of the fourth insulating layer PVX2, and k is the electrostatic force constant. For example, the capacitance of the main storage capacitor takes the area of the pixel electrode PE as the facing area of the two plates of the capacitor.

As shown in Fig. 3 and Fig. 8, the case where the first via hole V1 is circular and the second capacitor C2 is cylindrical capacitor is taken as an example for illustration.

As shown in Fig. 3 and Fig. 8, the capacitance of the storage capacitor C0 is C0 = ε_{BF2}*πR²/(4πk*THK_{BF2}), where ε_{BF2} is the dielectric constant of the first insulating layer BF (second insulating portion BF2), R is the radius of the first via hole V1, THK_{BF2} is the thickness of the insulating layer between the first electrode E1 and the light shielding layer LSL, that is, the thickness of the second insulating portion BF2, and k is the electrostatic force constant.

As shown in Fig. 3 and Fig. 8, the capacitance of the second capacitor C2 is C2 = [ε_{PVX1}*(2πR*(THK_{ILD}+THK_{GI}+THK_{BF1})]/[4πk*THK_{PVX1}], where ε_{PVX1} is the dielectric constant of the third insulating layer, R is the radius of the first via hole V1, THK_{ILD} is the thickness of the interlayer insulating layer ILD, and THK_{GI} is the thickness of the gate insulating layer. THK_{ILD}+THK_{GI} is the thickness of the second insulating layer 122, THK_{PVX1} is the thickness of the third insulating layer PVX1 between the first electrode E1 and the common electrode CE, and k is the electrostatic force constant.

Because the first insulating layer BF includes the first insulating portion BF1 and the second insulating portion BF2, ε_{BF2} = ε_{BF1} = ε_{BF}, where ε_{BF2} is the dielectric constant of the second insulating portion BF2, ε_{BF1} is the dielectric constant of the first insulating portion BF1, and ε_{BF} is the dielectric constant of the first insulating layer BF.

In order to simplify the calculation, it is assumed that the first insulating layer BF, the second insulating layer 122, the third insulating layer PVX1 and the fourth insulating layer PVX2 are made of the same material, and the interlayer insulating layer ILD and the gate insulating layer GI are made of the same material in the case where the second insulating layer 122 includes the interlayer insulating layer ILD and the gate insulating layer GI; then, each insulating layer has the same dielectric constant. For example, the material of the insulating layers can be silicon nitride, but it is not limited thereto.

For example, in the case where the first via hole V1 is circular, the ratio of the capacitance of the storage capacitor C0 to the capacitance of the main storage capacitor Cstm is CO/Cstm = [ε_{BF2}*πR²/(4πk*THK_{BF2})]/[ε_{PVX2}*W*H/(4πk*THK_{PVX2})] = [πR²* THK_{PVX2}]/[W*H*THK_{BF2}].

For example, as shown in Fig. 3 and Fig. 8, in the case where the first via hole V1 is circular, in the array substrate, the ratio CO/Cstm of the capacitance of the storage capacitor C0 to the capacitance of the main storage capacitor Cstm is greater than or equal to 0.2. For example, the capacitance ratio CO/Cstm is greater than or equal to 0.25. Further, for example, the ratio CO/Cstm of the capacitance of the storage capacitor C0 to the capacitance of the main storage capacitor Cstm is greater than or equal to 0.48. For example, the ratio CO/Cstm of the capacitance of the storage capacitor C0 to the capacitance of the main storage capacitor Cstm is greater than or equal to 0.50. For example, in the case where the first via hole V1 is circular, the ratio CO/Cstm of the capacitance of the storage capacitor C0 to the capacitance of the main storage capacitor Cstm is less than or equal to 0.8.

In some embodiments, in the case where the first via hole V1 is circular, 0.2≤C0/Cstm ≤0.8. For example, 0.25≤C0/Cstm≤ 0.8. For example, 0.48≤C0/Cstm ≤0.8. For example, 0.50≤C0/Cstm ≤0.8. For example, 0.50<C0/Cstm≤0.8.

For example, in some embodiments, R = 2.59µm, THK_{BF2} = 0.08µm, W = 1.7µm, and H = 21µm, and if these values are substituted into the formula of CO/Cstm, the ratio of the capacitance of the storage capacitor C0 to the capacitance of the main storage capacitor Cstm is CO/Cstm = 0.59. Of course, the values of the variables in the formula are not limited thereto.

For example, in the case where the first via hole V1 is circular, the ratio of the capacitance of the second capacitor C2 to the capacitance of the main storage capacitor Cstm is C2/Cstm = [ε_{PVX1}*(2πR*(THK_{ILD}+THK_{GI}+THK_{BF1})]/4πk*THK_{PVX1}]/[ε_{PVX2}*W* H/(4πk*THK_{PVX2}) = [2πR*(THK_{ILD}+THK_{GI}+THK_{BF1})*THK_{PVX2}]/(W*H*THK_{PVX1}).

For example, as shown in Fig. 3 and Fig. 8, in the case where the first via hole V1 is circular, the ratio C2/Cstm of the capacitance of the second capacitor C2 to the capacitance of the main storage capacitor Cstm is greater than or equal to 0.02. Further, for example, the ratio C2/Cstm of the capacitance of the second capacitor C2 to the capacitance of the main storage capacitor Cstm is greater than or equal to 0.03.

For example, in the case where the first via hole V1 is circular, the ratio C2/Cstm of the capacitance of the second capacitor C2 to the capacitance of the main storage capacitor Cstm is less than or equal to 0.2. Further, for example, the ratio C2/Cstm of the capacitance of the second capacitor C2 to the capacitance of the main storage capacitor Cstm is less than or equal to 0.1.

For example, in the case where the first via hole V1 is circular, 0.02≤C2/Cstm≤0.2; further, for example, 0.03≤C2/Cstm≤0.1; and further, for example, 0.06≤C2/Cstm≤0.08.

In some embodiments, R = 2.59µm, THK_{BF1} = 0.28µm, THK_{ILD} = 0.78µm, THK_{GI} = 0.11µm, THK_{PVX2} = 0.08µm, W = 1.7µm, H = 21µm, THK_{PVX1} = 0.52µm, and if these values are substituted into the formula of C2/Cstm, the ratio of the capacitance of the second capacitor C2 to the capacitance of the main storage capacitor Cstm is C2/Cstm = 0.08. Of course, the values of the variables in the formula are not limited thereto.

In the embodiment of the present disclosure, the capacitance of a capacitor can be calculated by the formula C=εS/4πkd, where ε is a constant, S is the facing area of the plates of the capacitor, d is the distance between the plates of the capacitor, and k is the electrostatic force constant. The calculation of the specific capacitance of each capacitor is subject to the calculation method and measurement method given in the present disclosure.

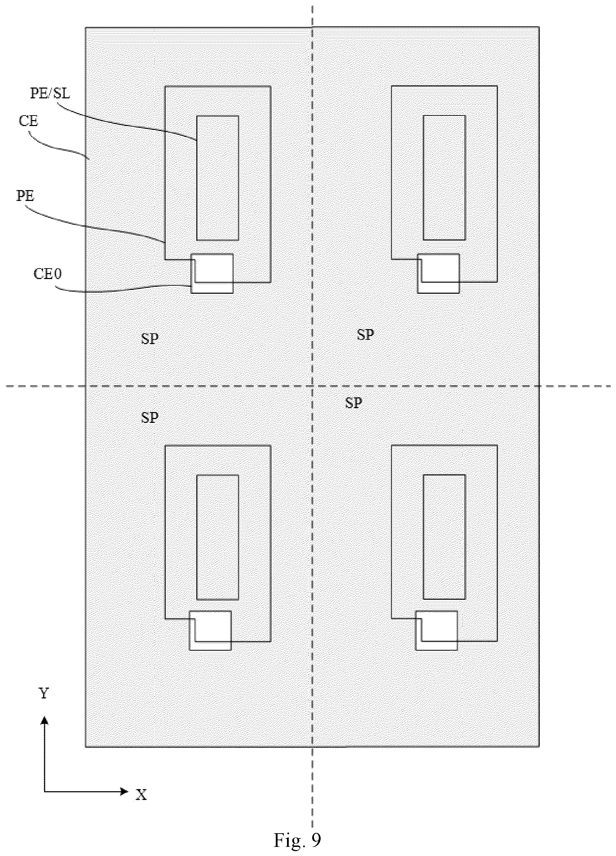

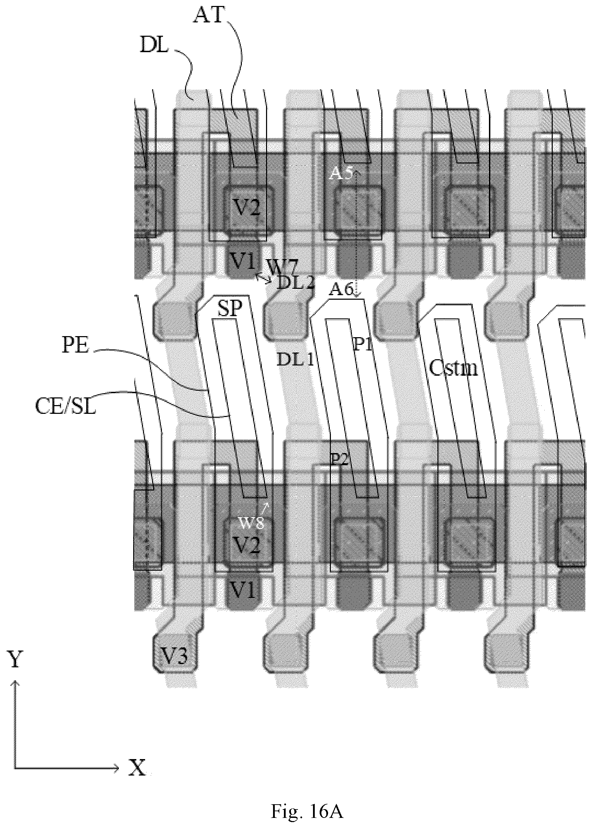

Fig. 9 is a schematic diagram of a common electrode in an array substrate provided by an embodiment of the present disclosure. As shown in Fig. 9, the common electrodes of the plurality of sub-pixels SP are of an integral structure. As shown in Fig. 2, Fig. 3 and Fig. 9, the slit SL is disposed in the pixel electrode PE, the pixel electrode PE is located above the common electrode CE, and the common electrode CE is provided with a hollow structure CE0 to facilitate the connection between the pixel electrode PE and the first electrode E1. Of course, in other embodiments, the common electrode CE may be located above the pixel electrode PE, and the slit SL may be arranged in the common electrode CE without having to provide the hollow structure CE0; and this case can be as shown in Fig. 16A.

For example, in the array substrate, the main storage capacitor Cstm is a storage capacitor in a plane parallel with the main surface MS.

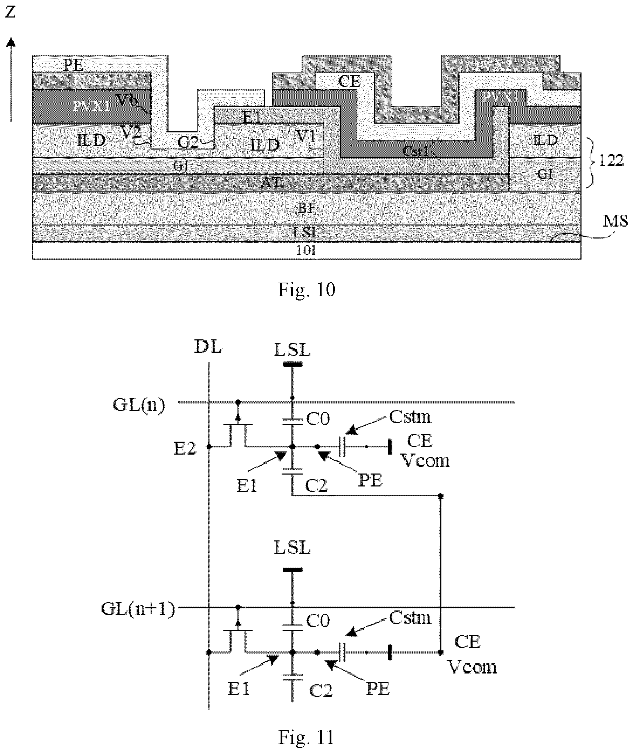

Fig. 10 is a cross-sectional view of an array substrate provided by an embodiment of the present disclosure. Fig. 11 is an equivalent circuit diagram of the array substrate shown in Fig. 10. As shown in Fig. 10 and Fig. 11, the array substrate includes a first storage capacitor Cst1 and does not include a second storage capacitor Cst2. As shown in Fig. 10, compared with the array substrate shown in Fig. 3, the first via hole V1 does not have a first groove G1, and the first electrode E1 is not connected with the side surface S2 of the active layer AT.

As shown in Fig. 10, an embodiment of the present disclosure further provides an array substrate, which includes: a base substrate 101, including a main surface MS; a transistor TR, located on the main surface MS of the base substrate 101, and including an active layer AT and a first electrode E1 connected with the active layer AT; a first insulating layer BF, located between the base substrate 101 and the active layer AT; a second insulating layer 122, located between the active layer AT and the first electrode E1; and a pixel electrode PE connected with the first electrode E1; the pixel electrode PE is in contact with the surface of the first electrode E1 facing away from the base substrate 101 and is in contact with the side surface of the first electrode E1.

For example, as shown in Fig. 10, the array substrate further includes: a third insulating layer PVX1, located on the first electrode E1; and a common electrode CE, located on the third insulating layer PVX1 and insulated from the pixel electrode PE; the pixel electrode PE and the common electrode CE are configured to form an electric field, the pixel electrode PE and the common electrode CE are conformal at the first via hole V1, and the pixel electrode PE and the common electrode CE form a main storage capacitor.

For example, as shown in Fig. 10, the array substrate further includes a fourth insulating layer PVX2, and the fourth insulating layer PVX2 is located between the pixel electrode PE and the common electrode CE.

For example, as shown in Fig. 10, the array substrate further includes a second via hole V2, the second via hole V2 includes a second through hole Vb and a second groove G2, the second through hole Vb penetrates the fourth insulating layer PVX2 and the third insulating layer PVX1, and the second groove G2 is located in the second insulating layer 122; the second groove G2 is located in a portion of the second insulating layer 122 close to the third insulating layer PVX1, and the pixel electrode PE is in contact with the surface of the first electrode E1 facing away from the base substrate 101, and is in contact with the side surface of the first electrode E1.

For example, as shown in Fig. 10, the maximum dimension of the second groove G2 in a plane parallel with the main surface MS is less than the minimum dimension of the second through hole Vb in the plane parallel with the main surface MS.

For example, as shown in Fig. 10, the maximum dimension of the second groove G2 in the direction perpendicular to the main surface MS is less than the maximum dimension of the second through hole Vb in the direction perpendicular to the main surface MS.

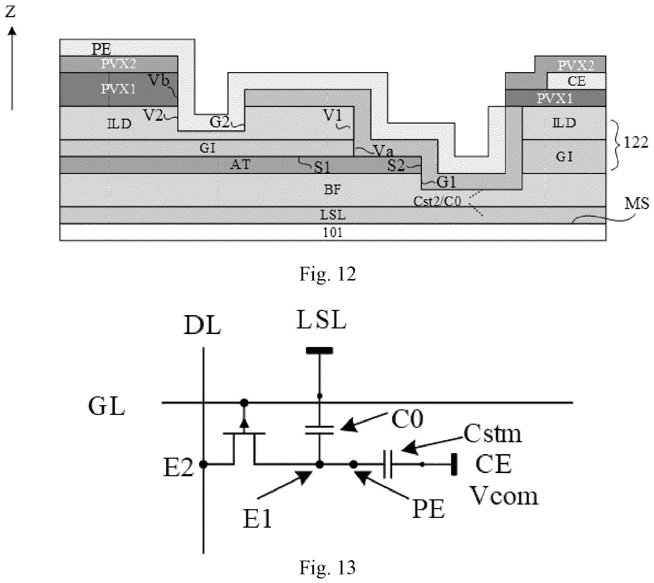

Fig. 12 is a cross-sectional view of an array substrate provided by an embodiment of the present disclosure. Fig. 13 is an equivalent circuit diagram of the array substrate shown in Fig. 12. As shown in Fig. 12 and Fig. 13, a compensation capacitor (storage capacitor C0, also called second storage capacitor Cst2) is provided in the sub-pixel. The pixel electrode PE and the first electrode E1 are formed as the upper electrode of the compensation capacitor, the light shielding layer LSL is formed as the lower electrode of the compensation capacitor; and the first insulating layer BF is over-etched and thinned to reduce the thickness of the insulating dielectric (of the compensation capacitor) and increase the compensation capacitance. As shown in Fig. 2, Fig. 12 and Fig. 13, the pixel electrode PE and the common electrode CE form a main storage capacitor Cstm, and the main storage capacitor Cstm is a storage capacitor in a plane parallel with the main surface MS.

As shown in Fig. 12, the pixel electrode PE is located on the fourth insulating layer PVX2, the common electrode CE is located on the third insulating layer PVX1, the fourth insulating layer PVX2 is located between the pixel electrode PE and the common electrode CE, and the pixel electrode PE is located on the common electrode CE. In this case, a slit SL is disposed in the pixel electrode PE. That is, the slit SL is disposed in one of the common electrode CE and the pixel electrode PE which is away from the base substrate 101.

For example, as shown in Fig. 12 and Fig. 13, in the array substrate, the ratio CO/Cstm of the capacitance of the storage capacitor C0 to the capacitance of the main storage capacitor Cstm can be referred to the above description, and details will not be repeated here.

For example, as shown in Fig. 12 and Fig. 13, the ratio C2/Cstm of the capacitance of the second capacitor C2 to the capacitance of the main storage capacitor Cstm can be referred to the above description, and details will not be repeated here.

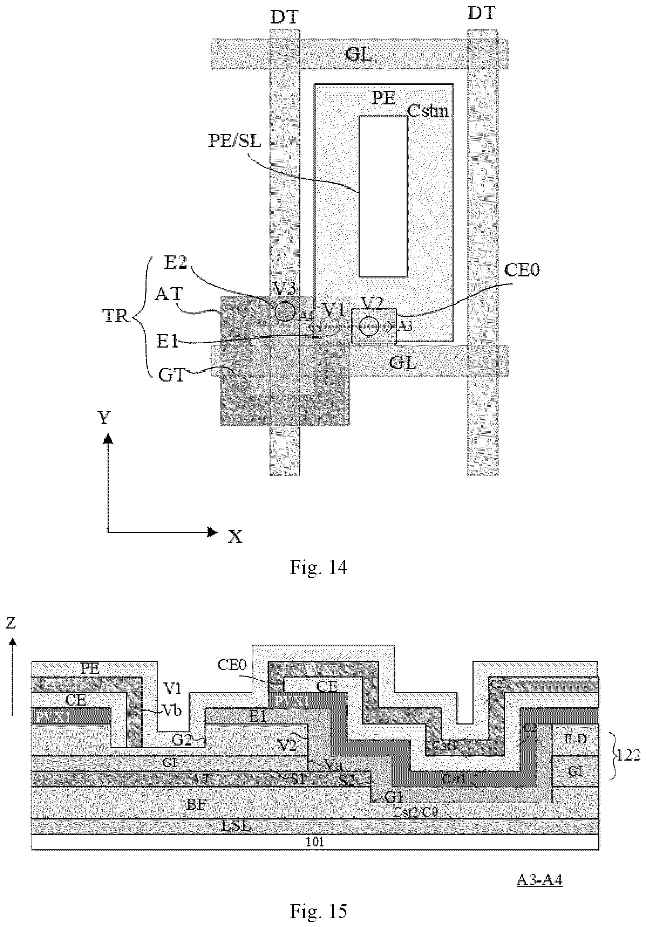

Fig. 14 is a plan view of an array substrate provided by an embodiment of the present disclosure. Fig. 15 is a cross-sectional view taken along line A3-A4 of Fig. 14. Fig. 14 omits the common electrode CE. For example, as shown in Fig. 15, in the array substrate, the common electrode CE is located between the first electrode E1 and the pixel electrode PE, the common electrode CE and the first electrode E1 form a first storage capacitor Cst1, and the common electrode CE and the pixel electrode PE form another first storage capacitor Cst1.

As shown in Fig. 14 and Fig. 15, a double-layered sidewall capacitor is formed at the first via hole V1 to increase the storage capacitance. The double-layered sidewall capacitor includes a first storage capacitor Cst1 formed by the common electrode CE and the first electrode E1, and another first storage capacitor Cst1 formed by the common electrode CE and the pixel electrode PE. The pixel electrode PE extends into the first via hole V1, and the pixel electrode PE, the common electrode CE, and the fourth insulating layer PVX2 located between the pixel electrode PE and the common electrode CE form a first storage capacitor Cst1 to increase the capacitance of the storage capacitor.

As shown in Fig. 14 and Fig. 15, the pixel electrode PE is located above the common electrode CE, and the pixel electrode PE has a slit SL.

As shown in Fig. 14 and Fig. 15, the common electrode CE has a hollow structure CE0 to facilitate the connection between the pixel electrode PE and the first electrode E1.

As shown in Fig. 14, the shape of the active layer AT is a rectangular ring with a notched corner, and the active layer AT passes through the gate line GL twice to form a double-gate transistor.

As shown in Fig. 14, the first channel CN1 and the second channel CN2 of the active layer AT are arranged to avoid the data line DL.

As shown in Fig. 14 and Fig. 15, the pixel electrode PE covers the first via hole V1 and the second via hole V2 at the first electrode E1.

Fig. 15 shows two second capacitors C2, and in this array substrate, the two second capacitors C2 double the compensation effect. The capacitance ratio of each second capacitor C2 to the main storage capacitor conforms to the above description. Thus, the capacitance brought by the second capacitors C2 is doubled.

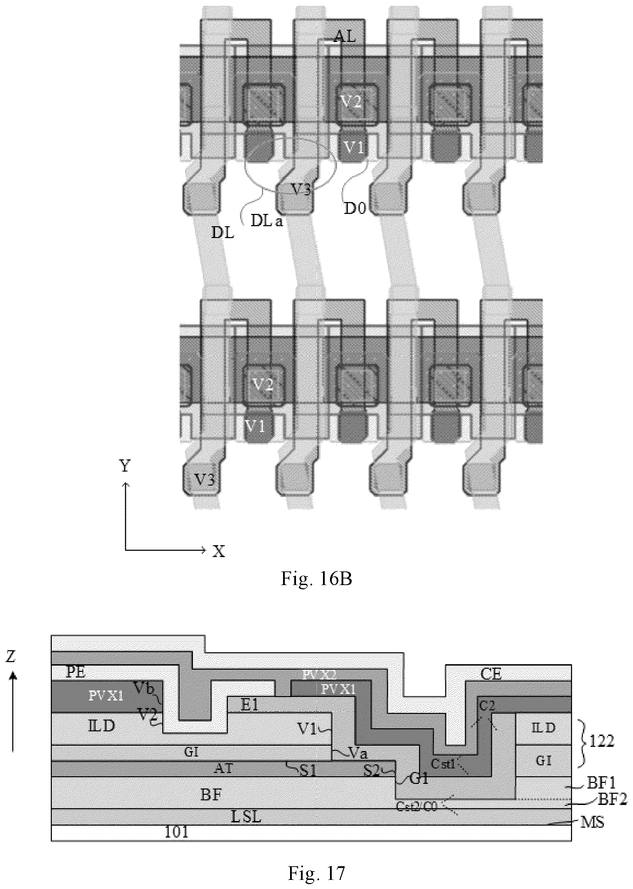

Fig. 16A is a plan view of an array substrate provided by an embodiment of the present disclosure. Fig. 16B is a plan view of an array substrate provided by an embodiment of the present disclosure. Fig. 17 is a cross-sectional view taken along line A5-A6 of Fig. 16A.

As shown in Fig. 16A, the first via hole V1, the second via hole V2, and the third via hole V3 are all rectangular. As shown in Fig. 16A, the channel of the active layer AT (a portion of the active layer AT overlapping with the gate line GL) overlaps with the data line DL.

In the high-PPI display screen, because the dimension of a single pixel can be reduced to about 7 microns*21 microns, the wiring space is reduced, and it is difficult for the channel of the active layer to avoid the data line. Moreover, the first via hole V1 and the second via hole V2 can be designed in other shapes, not necessarily circular, but can be square or other shapes, so that the second capacitor C2 (compensation capacitor) is not necessarily a cylindrical capacitor, but can be a sidewall capacitor perpendicular to the direction of the planar storage capacitor.

For example, as shown in Fig. 16A, in the mode of Advanced Super Dimension Switch (ADS) or Fringe Field Switching (FFS), the data line DL needs to be designed in a bent shape to match with the direction of the slit SL in the common electrode CE. The inclination direction of the data line DL is the same as the inclination direction of the slit SL of the common electrode.

As shown in Fig. 16B, the bending direction of the data line DL is parallel with the direction D0 of the notched corner of the first via hole V1; the minimum distance between the bending portion DLa of the data line DL and the notched corner of the first via hole V1 can be 3µm, and the minimum distance is in a range from 1 to 5 µm.

As shown in Fig. 16A and Fig. 17, the common electrode CE has a hollow structure CE0 to facilitate the connection between the pixel electrode PE and the first electrode E1.

Referring to Fig. 16A to Fig. 17, the first electrode E1 is connected with the active layer AT through the first via hole V1, and the pixel electrode PE is connected with the first electrode E1 through the second via hole V2. As shown in Fig. 17, the first via hole V1 is a half hole and the second via hole V2 is a half hole.

As shown in Fig. 16A, the first via hole V1 may adopt other shapes besides a circle. The shape of the first via hole V1 can be rectangular. Fig. 16A takes that the first via hole V1 is a rectangle with a notched corner as an example.

The capacitance of the main storage capacitor is the same as that in the case where the first via hole V1 is circular. That is, as shown in Fig. 8, Fig. 16A and Fig. 17, the capacitance of the main storage capacitor is Cstm = ε_{PVX2}*W*H/(4πk*THK_{PVX2}), where ε_{PVX2} is the dielectric constant of the fourth insulating layer PVX2; W is the width of the pixel electrode PE, that is, the dimension of the pixel electrode PE in the direction X; H is the length of the pixel electrode PE, that is, the dimension of the pixel electrode PE in the direction Y; THK_{PVX2} is the thickness of the fourth insulating layer PVX2, and k is the electrostatic force constant.

As shown in Fig. 16A, the first via hole V1 is rectangular and the second capacitor C2 is a rectangular pillar, which is taken an example for illustration. The embodiment of the present disclosure is illustrated by taking that the first via hole V1 is a square hole, the length Lₕ of the first via hole V1 is 3µm, and the width Wₕ of the first via hole V1 is 3µm as an example. Of course, the dimension of the first via hole V1 can be determined as needed.

As shown in Fig. 16A and Fig. 17, the capacitance C0 of the storage capacitor is C0 = ε_{BF2}*Lₕ*Wₕ/(4πk*THK_{BF2}), where ε_{BF2} is the dielectric constant of the first insulating layer BF (second insulating portion BF2), Lₕ is the length of the first via hole V1, Wₕ is the width of the first via hole V1, THK_{BF2} is the thickness of the insulating layer between the first electrode E1 and the light shielding layer LSL, that is, the thickness of the second insulating portion BF2, and k is the electrostatic force constant. Lₕ*Wₕ is the area of the rectangular first via hole V1.

As shown in Fig. 6, Fig. 16A and Fig. 17, the capacitance C2 of the second capacitor (sidewall capacitor) is C2 = [ε_{PVX1}*(2Lₕ+2Wₕ)*(THK_{ILD}+THK_{GI}+THK_{BF1})]/[4πk* THK_{PVX1}], where ε_{PVX1} is the dielectric constant of the third insulating layer, Lₕ is the length of the first via hole V1, Wₕ is the width of the first via hole V1, THK_{ILD} is the thickness of the interlayer insulating layer ILD, and THK_{GI} is the thickness of the gate insulating layer GI. THK_{ILD}+THK_{GI} is the thickness of the second insulating layer 122, THK_{PVX1} is the thickness of the third insulating layer PVX1 between the first electrode E1 and the common electrode CE, and k is the electrostatic force constant. (2Lₕ+2Wₕ) is the perimeter of the rectangular first via hole V1.

Similarly, because the first insulating layer BF includes the first insulating portion BF1 and the second insulating portion BF2, ε_{BF2} = ε_{BF1} = ε_{BF}, where ε_{BF2} is the dielectric constant of the second insulating portion BF2, ε_{BF1} is the dielectric constant of the first insulating portion BF1, and ε_{BF} is the dielectric constant of the first insulating layer BF.

Similarly, in order to simplify the calculation, it is assumed that the first insulating layer BF, the second insulating layer 122, the third insulating layer PVX1 and the fourth insulating layer PVX2 are made of the same material, and the interlayer insulating layer ILD and the gate insulating layer GI are made of the same material in the case where the second insulating layer 122 includes the interlayer insulating layer ILD and the gate insulating layer GI; then, each insulating layer has the same dielectric constant. For example, the material of the insulating layers can be silicon nitride, but it is not limited thereto.

For example, in the case where the first via hole V1 is rectangular, the ratio of the capacitance of the storage capacitor C0 to the capacitance of the main storage capacitor Cstm is CO/Cstm = [ε_{BF2}*Lₕ*Wₕ/(4πk*THK_{BF2})]/[ε_{PVX2}*W*H/(4πk*THK_{PVX2})] = [Lₕ* Wₕ*THK_{PVX2}]/[W*H*THK_{BF}].

For example, in the case where the first via hole is rectangular, in the array substrate, the ratio CO/Cstm of the capacitance of the storage capacitor C0 to the capacitance of the main storage capacitor Cstm is greater than or equal to 0.2. For example, the capacitance ratio CO/Cstm is greater than or equal to 0.25. Further, for example, the ratio CO/Cstm of the capacitance of the storage capacitor C0 to the capacitance of the main storage capacitor Cstm is greater than or equal to 0.48. For example, the ratio CO/Cstm of the capacitance of the storage capacitor C0 to the capacitance of the main storage capacitor Cstm is greater than or equal to 0.50.

For example, in the case where the first via hole V1 is rectangular, the ratio CO/Cstm of the capacitance of the storage capacitor C0 to the capacitance of the main storage capacitor Cstm is less than or equal to 0.8.

In some embodiments, in the case where the first via hole V1 is rectangular, 0.2≤ C0/Cstm≤0.8. For example, 0.25≤C0/Cstm≤ 0.8. For example, 0.48≤C0/Cstm ≤0.8. For example, 0.50≤C0/Cstm ≤0.8. For example, 0.50<C0/Cstm≤0.8.

For example, in some embodiments, Lₕ = 3µm, Wₕ = 3µm, THK_{BF2} = 0.08µm, W = 1.7µm, and H = 21µm, and if these values are substituted into the formula of CO/Cstm, the ratio of the capacitance of the storage capacitor C0 to the capacitance of the main storage capacitor Cstm is CO/Cstm = 0.252. Of course, the values of the variables in the formula are not limited thereto.

For example, the ratio of the capacitance of the second capacitor C2 to the capacitance of the main storage capacitor Cstm is C2/Cstm = [ε_{PVX1}*(2Lₕ+2Wₕ)* (THK_{ILD}+THK_{GI}+THK_{BF1})]/[4πk*THK_{PVX1}]/[ε_{PVX2}*W*H/(4πk*THK_{PVX2})] = [(2Lₕ+2Wₕ) *(THK_{ILD}+THK_{GI}+THK_{BF1})*THK_{PVX2}]/(W*H*THK_{PVX1}).

For example, as shown in Fig. 16A and Fig. 17, in the case where the first via hole V1 is rectangular, the ratio C2/Cstm of the capacitance of the second capacitor C2 to the capacitance of the main storage capacitor Cstm is greater than or equal to 0.02. Further, for example, the ratio C2/Cstm of the capacitance of the second capacitor C2 to the capacitance of the main storage capacitor Cstm is greater than or equal to 0.03.

For example, in the case where the first via hole V1 is rectangular, the ratio C2/Cstm of the capacitance of the second capacitor C2 to the capacitance of the main storage capacitor Cstm is less than or equal to 0.2. Further, for example, the ratio C2/Cstm of the capacitance of the second capacitor C2 to the capacitance of the main storage capacitor Cstm is less than or equal to 0.1.

For example, in the case where the first via hole V1 is rectangular, 0.02≤C2/Cstm≤0.2; further, for example, 0.03≤C2/Cstm≤0.1; and further, for example, 0.06≤C2/Cstm≤0.08.

In some embodiments, Lₕ = 3µm, Wₕ = 3µm, THK_{BF1} = 0.28µm, THK_{ILD} = 0.78µm, THK_{GI} = 0.11µm, THK_{PVX2} = 0.08µm, W = 1.7µm, H = 21µm, THK_{PVX1} = 0.52µm, and if these values are substituted into the formula of C2/Cstm, the ratio of the capacitance of the second capacitor C2 to the capacitance of the main storage capacitor Cstm is C2/Cstm = 0.06. Of course, the values of the variables in the formula are not limited thereto.

Therefore, in the embodiment of the present disclosure, regardless of the shape of the first via hole V1, the ratio CO/Cstm of the capacitance of the storage capacitor C0 to the capacitance of the main storage capacitor Cstm is within the range given above, and the ratio C2/Cstm of the capacitance of the second capacitor C2 to the capacitance of the main storage capacitor Cstm is within the range given above.

In the embodiment of the present disclosure, a capacitor and the capacitance of the capacitor are represented by the same symbol.

For example, as shown in Fig. 8 and Fig. 16A, the width of the sub-pixel can be in the range of 2-7 µm, and the length of the sub-pixel can be in the range of 15-60 µm.

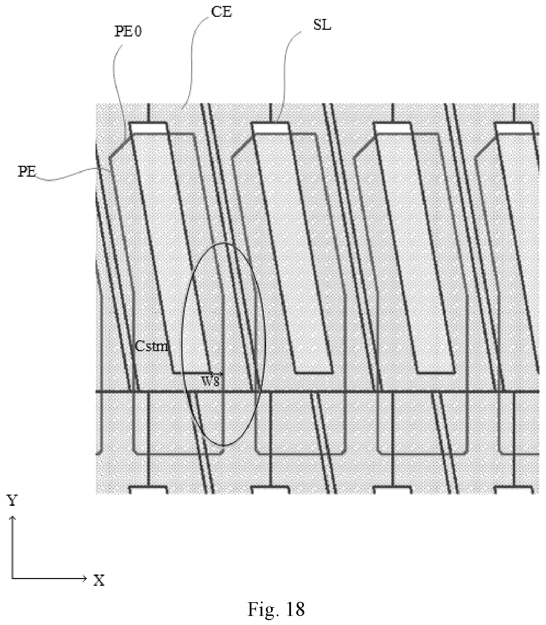

Fig. 18 is a plan view of an array substrate provided by an embodiment of the present disclosure. As shown in Fig. 18, the common electrode CE has a slit SL, the slit SL of the common electrode CE is not bent, the pixel electrode PE is plate-shaped. The shape/orientation and spacing of the pixel electrode PE are as follows: (1) the pixel electrode PE has a notched corner PE0; (2) the edge of the upper portion of the pixel electrode PE is parallel with the edge of the slit SL of the common electrode and also parallel with the data line; (3) the edge of the lower portion of the pixel electrode PE is not parallel with the edge of the slit SL of the common electrode, but parallel with the data line; (4) the minimum distance between the edge of the lower portion of the pixel electrode PE and the edge of the slit SL of the common electrode is less than 1 µm; the pixel electrode PE of the former row of sub-pixels covers the first via hole V1 of the latter row of sub-pixels (the via hole through which the first electrode E1 of the transistor TR is connected with the active layer AT).

For example, as shown in Fig. 16A, the data line DL includes a plurality of inclined portions DL1, a bending portion DL2 is arranged between adjacent inclined portions DL1, the extension direction of the inclined portion DL1 is the same as the extension direction of the slit SL, and the first via hole V1 has a chamfer, and the extension direction of the edge of the first via hole V1 at the chamfer is the same as the extension direction of the bending portion.

For example, as shown in Fig. 16A, the distance W7 between the edge of the first via hole V1 at the chamfer and the bending portion DL2 is greater than or equal to 1 micron and less than or equal to 5 microns.

For example, as shown in Fig. 16A, the pixel electrode PE has a first portion P1 and a second portion P2 with different extension directions, the extension direction of the first portion P1 is the same as the extension direction of the slit SL, and the edge of the first portion P1 is parallel with the edge of the slit SL, and is parallel with the edge of the data line DL.

For example, as shown in Fig. 16A, the edge of the second portion P2 is not parallel with the edge of the slit SL, and the edge of the second portion P2 is parallel with the data line DL.

For example, as shown in Fig. 16A and Fig. 18, the minimum distance W8 between the edge of the second portion P2 and the edge of the slit SL is less than 1 micron. W8 is shown at the ellipse in Fig. 18.

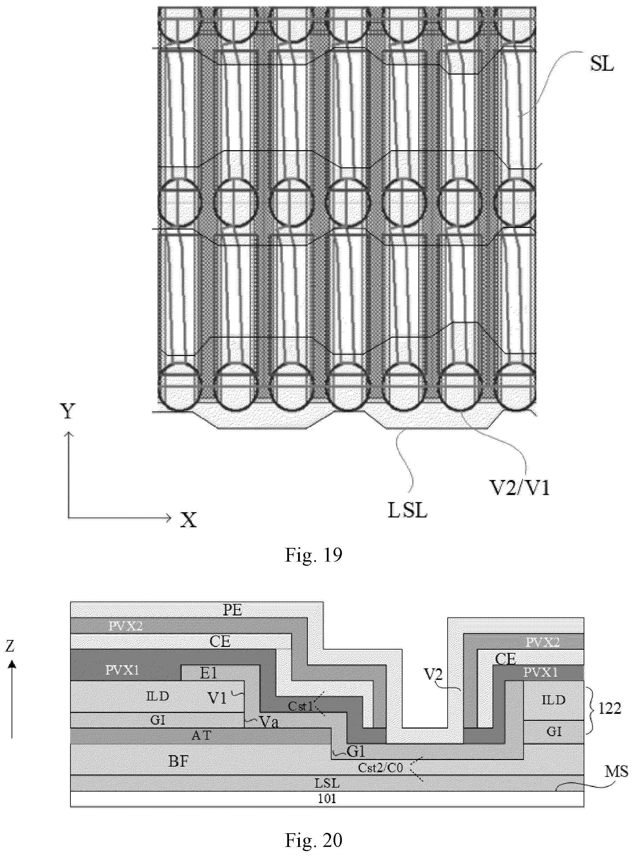

Fig. 19 is a plan view of an array substrate provided by an embodiment of the present disclosure. Fig. 20 is a cross-sectional view of an array substrate provided by an embodiment of the present disclosure.

For example, as shown in Fig. 19 and Fig. 20, the array substrate further includes a first via hole V1, the first electrode E1 is connected with the active layer AT through the first via hole V1, the pixel electrode PE is in contact with the surface of the first electrode E1 facing away from the base substrate 101, and the orthographic projection of the first via hole V1 on the base substrate 101 overlaps with the orthographic projection of the second via hole V2 on the base substrate 101.

For example, as shown in Fig. 20, the first via hole V1 includes a first through hole Va penetrating the second insulating layer 122 and a first groove G1 located in the first insulating layer BF, and the first groove G1 is located in a portion of the first insulating layer BF close to the second insulating layer 122, so as to facilitate the contact between the first electrode E1 and the side surface of the active layer AT, thereby increasing the compensation capacitance in the direction Z, and increasing the storage capacitance.

For example, as shown in Fig. 20, the second via hole V2 penetrates the third insulating layer PVX1 and the fourth insulating layer PVX2.

For example, as shown in Fig. 20, the first electrode E1 and the common electrode CE form a first storage capacitor Cst1.

For example, as shown in Fig. 20, the array substrate further includes a light shielding layer LSL, the light shielding layer LSL is located between the active layer AT and the base substrate 101, the orthographic projection of the active layer AT on the base substrate 101 falls within the orthographic projection of the light shielding layer LSL on the base substrate 101, and the first electrode E1 and the light shielding layer LSL form a second storage capacitor Cst2.

As shown in Fig. 20, the light shielding layer LSL is floating. In the embodiment of the present disclosure, being floating means not being connected with any signal.

For example, as shown in Fig. 20, in the array substrate, the pixel electrode PE extends into the first via hole V1 and is in contact with the first electrode E1 at the first via hole V1.

As shown in Fig. 19 and Fig. 20, in the case of high PPI, double holes need to be changed into a single hole. In this case, the two compensation capacitors (storage capacitor C0 and second capacitor C2) and the capacitance ratio of each compensation capacitor to the main storage capacitor Cstm are kept approximately unchanged from the above description.

The array substrate shown in Fig. 19 and Fig. 20 is in the ADS mode, and the pixel electrode PE has a slit SL, but the first via hole V1 and the second via hole V2 overlap with each other.

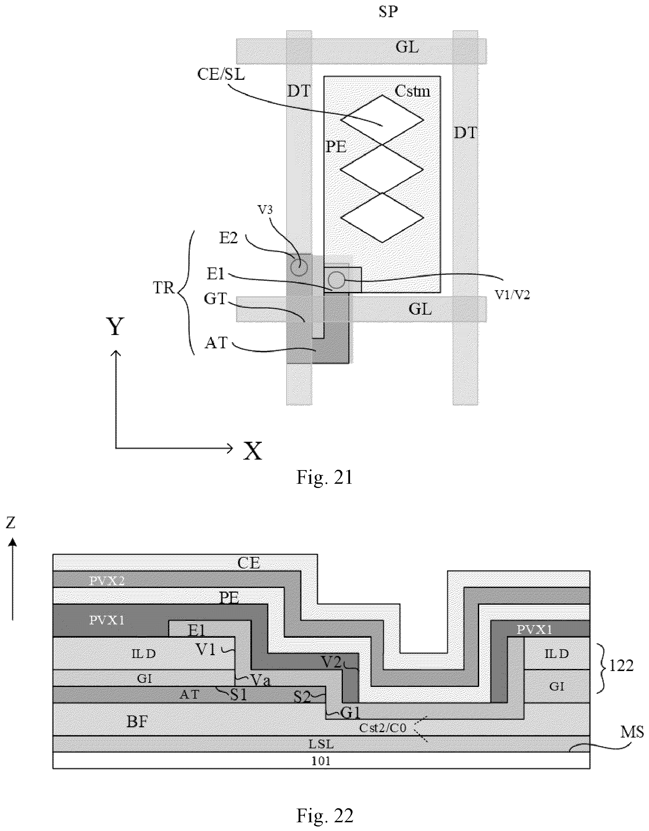

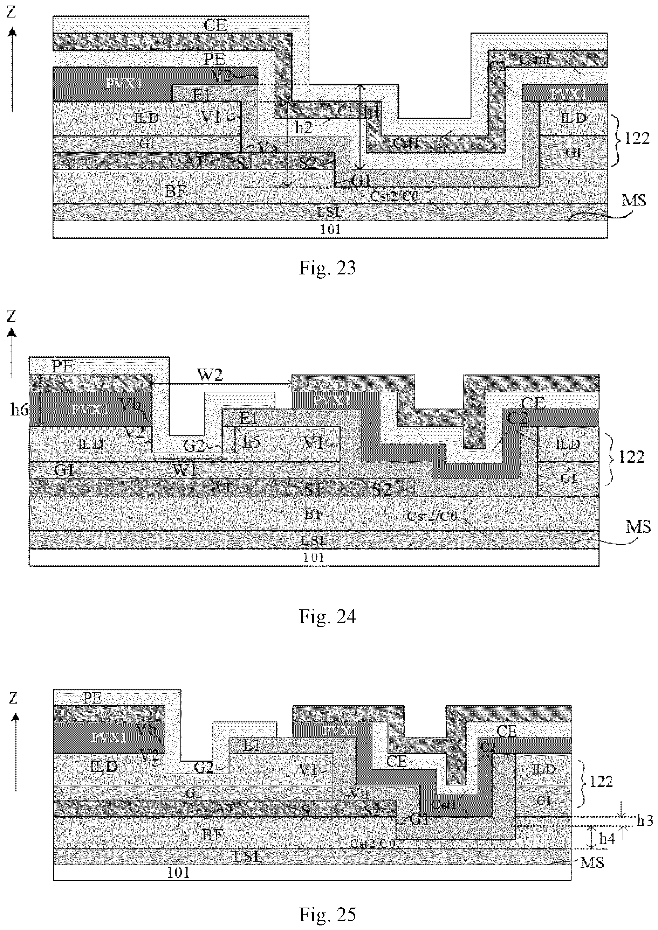

Fig. 21 is a plan view of an array substrate provided by an embodiment of the present disclosure. Fig. 22 is a cross-sectional view of an array substrate provided by an embodiment of the present disclosure. Fig. 23 is a cross-sectional view of an array substrate provided by an embodiment of the present disclosure.

For example, as shown in Fig. 22 and Fig. 23, the array substrate further includes a third insulating layer PVX1 and a common electrode CE, and the third insulating layer PVX1 is located on the first electrode E1; the common electrode CE is located on the third insulating layer PVX1 and insulated from the pixel electrode PE, the pixel electrode PE and the common electrode CE are configured to form an electric field, at least one of the first electrode E1 and the pixel electrode CE forms a first storage capacitor Cst1 with the common electrode CE, the first storage capacitor Cst1 includes a first capacitor C1 in a plane parallel with the main surface MS and a second capacitor C2 in a direction perpendicular to the main surface MS. For example, the ratio CO/Cstm of the capacitance of the storage capacitor C0 to the capacitance of the main storage capacitor Cstm can be referred to the above description. For example, the ratio C2/Cstm of the capacitance of the second capacitor C2 to the capacitance of the main storage capacitor Cstm can be referred to the above description.

For example, as shown in Fig. 22 and Fig. 23, in the array substrate, the main storage capacitor Cstm is a storage capacitor in the plane parallel with the main surface MS.

For example, the array substrate further includes a light shielding layer LSL, the light shielding layer LSL is located between the active layer AT and the base substrate 101, the orthographic projection of the active layer AT on the base substrate 101 falls within the orthographic projection of the light shielding layer LSL on the base substrate 101, and the first electrode E1 and the light shielding layer LSL form a storage capacitor C0 (second storage capacitor Cst2).

For example, the light shielding layer LSL is floating or the light shielding layer LSL is electrically connected with the common electrode CE. As shown in Fig. 22 and Fig. 23, the light shielding layer LSL is floating. The light shielding layer LSL is electrically connected with the common electrode CE so that they are at the same potential.

For example, as shown in Fig. 22 and Fig. 23, in the array substrate, the pixel electrode PE extends into the first via hole V1 and is in contact with the first electrode E1 at the first via hole V1.

For example, as shown in Fig. 23, the pixel electrode PE and the first electrode E1 are conformal at the first via hole V1, and the maximum dimension h2 of the portion of the pixel electrode PE in contact with the first electrode E1 in the direction perpendicular to the main surface MS is greater than or equal to the maximum dimension h1 of the first via hole V1 in the direction perpendicular to the main surface MS.

For example, as shown in Fig. 23, the pixel electrode PE and the common electrode CE are conformal at the first via hole V1, the pixel electrode PE and the common electrode CE form a first storage capacitor Cst1 at the first via hole V1, and the pixel electrode PE and the common electrode CE form a main storage capacitor Cstm.

Compared with the array substrate shown in Fig. 22, the contact area between the first electrode E1 and the pixel electrode PE in the array substrate shown in Fig. 23 is further increased.

Referring to Fig. 21 to Fig. 23, the array substrate is in a multi-domain ADS or FFS or Vertical Alignment (VA) mode with a wide viewing angle, and the electrical connection between the first electrode E1 and the active layer AT, the electrical connection between the pixel electrode PE and the first electrode E1, and the formation of one or more compensation capacitors are realized in a via hole.

Fig. 24 is a cross-sectional view of an array substrate provided by an embodiment of the present disclosure. Fig. 25 is a cross-sectional view of another array substrate provided by an embodiment of the present disclosure.

In Fig. 24, the first insulating layer BF is not over-etched. For example, as shown in Fig. 24, in the array substrate, the maximum thickness of the first insulating layer BF is in a range from 50nm to 300nm, so that the storage capacitor C0 has a large capacitance and achieves the compensation function. By providing a thinner first insulating layer BF, the thickness of the dielectric layer between the first electrode E1 and the light shielding layer LSL is smaller, so that a larger storage capacitor C0 can be obtained and a better compensation effect can be obtained. In the embodiment of the present disclosure, a storage capacitor C0 with a larger capacitance is obtained by making the dielectric layer between the first electrode E1 and the light shielding layer LSL have a smaller thickness. Obtaining a smaller dielectric layer can be achieved by over-etching the first insulating layer BF or providing a thinner first insulating layer BF.

The first insulating layer BF in Fig. 25 is over-etched. For example, as shown in Fig. 25, in the array substrate, the maximum dimension h3 of the first groove G1 in the direction perpendicular to the base substrate 101 is greater than the maximum dimension h4 of the portion of the first insulating layer BF directly below the first groove G1 in the direction perpendicular to the base substrate 101. Of course, in other embodiments, h3 can also be equal to or less than h4.

For example, the process of over-etching the first insulating layer BF can be realized in the process of patterning the active layer, and the over-etching of the first insulating layer BF can be realized by using the process required for etching the material of the active layer, such as poly-silicon, oxide semiconductor or amorphous silicon, etc. The process gas or liquid used to etch the material of the active layer will also etch a part of the material of the first insulating layer BF. For example, the material of the first insulating layer BF includes silicon oxide or silicon nitride. That is, the over-etching of the first insulating layer BF and the formation of the active layer are performed simultaneously. That is, during the patterning and etching process of the active layer, the first groove G1 is formed. Of course, the over-etching of the first insulating layer BF is not limited to the above manner.

For example, as shown in Fig. 24 and Fig. 25, the array substrate further includes a fourth insulating layer PVX2, and the fourth insulating layer PVX2 is located between the pixel electrode PE and the common electrode CE. As shown in Fig. 24 and Fig. 25, the pixel electrode PE is located above the common electrode CE, and the fourth insulating layer PVX2 is provided between the pixel electrode PE and the common electrode CE.

For example, as shown in Fig. 24 and Fig. 25, the array substrate further includes a second via hole V2, the second via hole V2 includes a second through hole Vb and a second groove G2, the second through hole Vb penetrates the fourth insulating layer PVX2 and the third insulating layer PVX1, and the second groove G2 is located in the second insulating layer 122. The second groove G2 is located in a portion of the second insulating layer 122 close to the third insulating layer PVX1, the pixel electrode PE is in contact with the surface S1 of the first electrode E1 facing away from the base substrate 101, and is in contact with the side surface S2 of the first electrode E1, so as to increase the contact area of side surfaces and to increase the dimension of the first electrode E1 in the direction Z, thereby increasing the capacitance of a storage capacitor (compensation capacitor) formed by the first electrode E1 and another electrode (e.g., the common electrode CE) in the direction Z.

For example, as shown in Fig. 24 and Fig. 25, the maximum dimension W1 of the second groove G2 in a plane parallel with the main surface MS is less than the minimum dimension W2 of the second through hole Vb in the plane parallel with the main surface MS, and W1 and W2 are marked in Fig. 24.

For example, as shown in Fig. 25, the maximum dimension h5 of the second groove G2 in the direction perpendicular to the main surface MS is less than the maximum dimension h6 of the second through hole Vb in the direction perpendicular to the main surface MS, and h5 and h6 are marked in Fig. 24.

For example, as shown in Fig. 25, the array substrate further includes a fourth insulating layer PVX2 and a second via hole V2, the fourth insulating layer PVX2 is located between the pixel electrode PE and the common electrode CE, the second via hole V2 includes a second through hole Vb and a second groove G2, the second through hole Vb penetrates the third insulating layer PVX1 and the fourth insulating layer PVX2, and the second groove G2 is located in the second insulating layer 122. The second groove G2 is located in a portion of the second insulating layer 122 close to the third insulating layer PVX1.

For example, as shown in Fig. 25, in the array substrate, the pixel electrode PE is in contact with the surface S1 of the first electrode E1 facing away from the base substrate 101, and is in contact with the side surface S2 of the first electrode E1.

For example, the array substrate shown in Fig. 24 and Fig. 25 is described with the case where the light shielding layer LSL is floating as an example. In other embodiments, the light shielding layer LSL can be electrically connected with the common electrode CE.

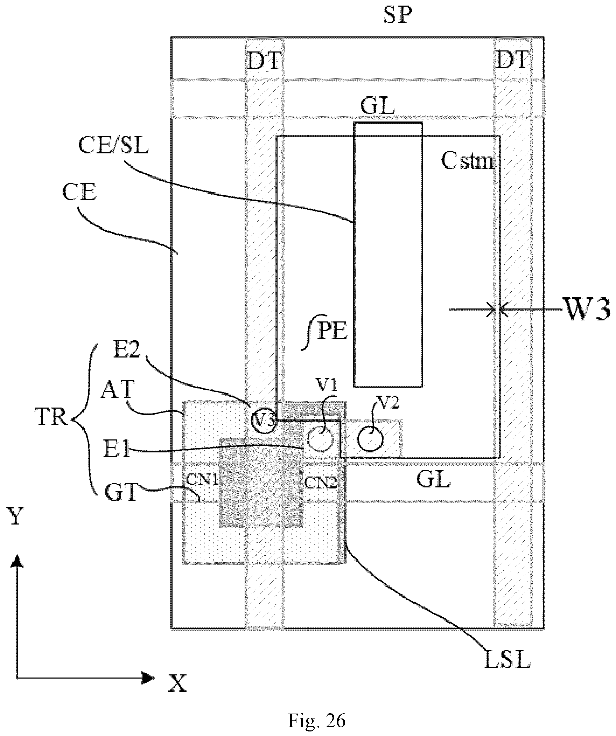

Fig. 26 is a plan view of an array substrate provided by an embodiment of the present disclosure. As shown in Fig. 26, the array substrate further includes a data line DL, the transistor TR further includes a second electrode E2, the second electrode E2 is connected with the active layer AT, the data line DL is connected with the second electrode E2, and the orthographic projection of the pixel electrode PE on the base substrate 101 overlaps with the orthographic projection of the data line DL on the base substrate 101. For example, the width W3 of the portion of the pixel electrode PE overlapping with the data line DL is less than 3 microns.

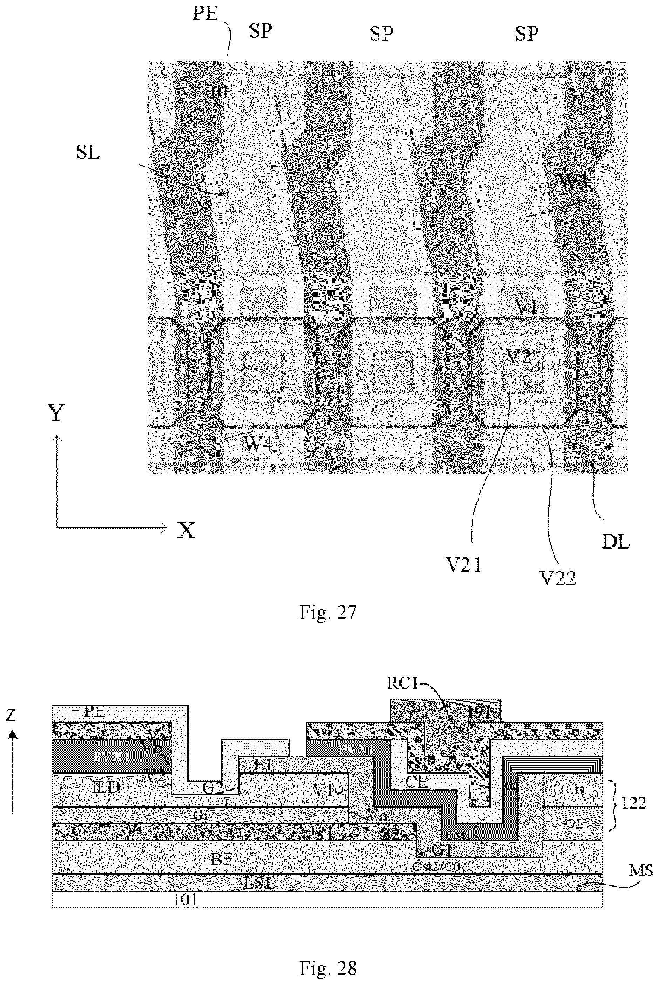

Fig. 27 is a plan view of an array substrate provided by an embodiment of the present disclosure. In the high-PPI display screen, because the dimension of a single pixel can be reduced to about 7 microns*21 microns, the wiring space is reduced. The first via hole V1 and the second via hole V2 need to be designed in a square shape to match with the electrode shapes and wiring in different display modes, so that the second capacitor C2 (compensation capacitor) is not necessarily a cylindrical capacitor, but can be a sidewall capacitor perpendicular to the direction of the planar storage capacitor. For example, as shown in Fig. 27, the array substrate is in the ADS mode, the first via hole V1 is square, and the second via hole V2 is square. Fig. 27 shows the bottom V21 and the top V22 of the second via hole V2, and the dimension of the top V22 is greater than the dimension of the bottom V21.

As shown in Fig. 27, the data line DL is bent, and the pixel electrode PE or the slit SL of the common electrode CE also has a certain inclination angle (in the range of 1-20 degrees) with the data line, and the edge of the pixel electrode PE and the slit SL of the common electrode partially overlap with the data line, respectively, and the overlapping width is less than 3 microns. Fig. 27 shows the maximum width W3 of the portion of the pixel electrode PE overlapping with the data line and the maximum width W4 of the portion of the slit SL overlapping with the data line DL. W3 is less than 3 microns, and W4 is less than 3 microns.

For example, in the embodiment of the present disclosure, the array substrate further includes a common electrode CE, and one of the pixel electrode PE and the common electrode CE which is away from the base substrate 101 has a slit SL, and the pixel electrode PE and the common electrode CE are configured to form an electric field. As shown in Fig. 27, the orthographic projection of the slit SL on the base substrate 101 overlaps with the orthographic projection of the data line DL on the base substrate 101. For example, the width W4 of the portion of the slit SL overlapping with the data line DL is less than 3 microns, but it is not limited thereto.

For example, as shown in Fig. 27, the included angle θ1 between the data line DL and the slit SL is in a range from 1 degree to 20 degrees.

For example, in the embodiment of the present disclosure, the shape of the first via hole V1 includes at least one of a circle, a rectangle, or a chamfered rectangle, but it is not limited thereto, and can be determined as needed.

Fig. 28 is a cross-sectional view of an array substrate provided by an embodiment of the present disclosure. For example, as shown in Fig. 28, the array substrate further includes a first protection structure 191, the orthographic projection of the first protection structure 191 on the base substrate 101 overlaps with the orthographic projection of the first via hole V1 on the base substrate 101, a portion of the first protection structure 191 is filled in a first recess RC1 at the first via hole V1, and a portion of the first protection structure 191 protrudes from the first recess RC1.

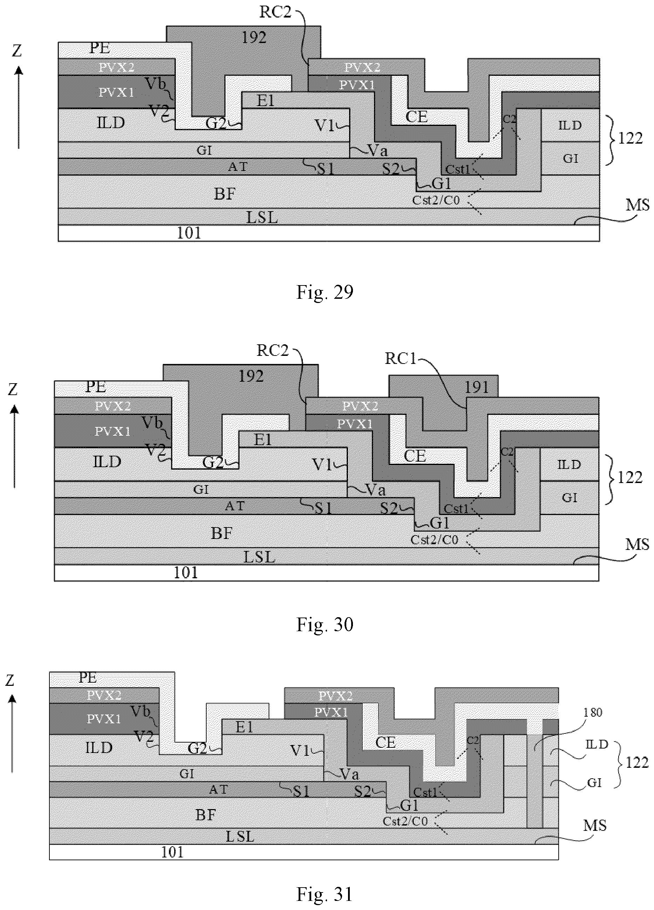

Fig. 29 is a cross-sectional view of an array substrate provided by an embodiment of the present disclosure. For example, as shown in Fig. 29, the array substrate further includes a second protection structure 192, the orthographic projection of the second protection structure 192 on the base substrate 101 overlaps with the orthographic projection of the second via hole V2 on the base substrate 101, a portion of the second protection structure 192 is filled in a second recess RC2 at the second via hole V2, and a portion of the second protection structure 192 protrudes from the second recess RC2.

Fig. 30 is a cross-sectional view of an array substrate provided by an embodiment of the present disclosure. Fig. 30 shows the first protection structure 191 and the second protection structure 192. The first protection structure 191 and the second protection structure 192 can be referred to those shown in Fig. 28 and Fig. 29, respectively. Of course, the first protection structure 191 and the second protection structure 192 can also be merged to form an integral structure.

For example, the first protection structure 191, the second protection structure 192 or the merged protection structure can be made of metal or an organic material, and can be formed into an integral structure with an anti-static structure or a spacer. The spacer is configured to support the cell thickness of the liquid crystal cell, and can be manufactured on the array substrate or disposed on the opposing substrate.

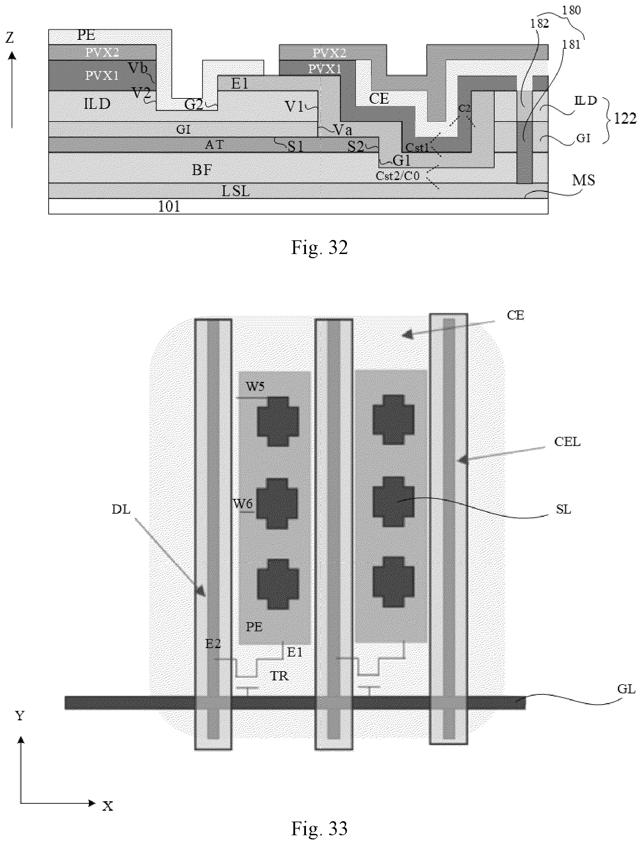

Fig. 31 is a cross-sectional view of an array substrate provided by an embodiment of the present disclosure. Fig. 32 is a cross-sectional view of an array substrate provided by an embodiment of the present disclosure. As shown in Fig. 31 and Fig. 32, the array substrate includes a connection electrode 180. The common electrode CE is connected with the light shielding layer LSL through the connection electrode 180. The connection electrode 180 in Fig. 31 can be located in the same layer as the first electrode E1. The connection electrode 180 in Fig. 32 includes a first connection portion 181 and a second connection portion 182. As shown in Fig. 32, the first connection portion 181 can be located in the same layer as the gate line GL, and the second connection portion 182 can be located in the same layer as the first electrode E1.

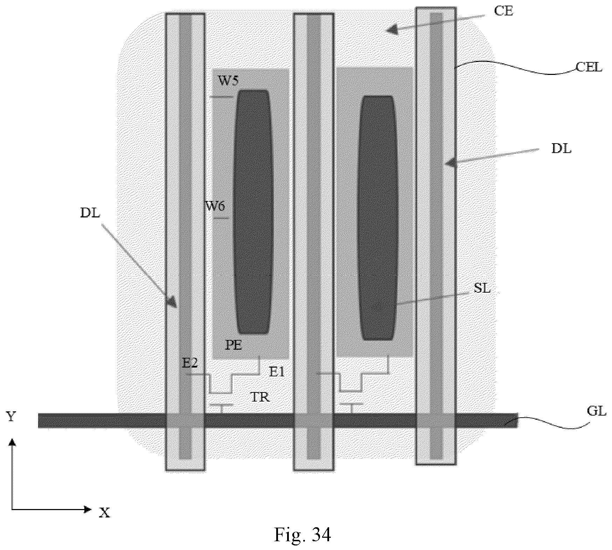

Fig. 33 is a plan view of an array substrate provided by an embodiment of the present disclosure. Fig. 34 is a plan view of an array substrate provided by an embodiment of the present disclosure.

For example, as shown in Fig. 17, Fig. 33 and Fig. 34, the array substrate further includes a data line DL and a common electrode CE, the transistor TR further includes a second electrode E2, the second electrode E2 is connected with the active layer AT, the data line DL is connected with the second electrode E2, the pixel electrode PE and the common electrode CE are configured to form an electric field, the pixel electrode PE is located between the common electrode CE and the base substrate 101, and the common electrode CE has a slit SL.

For example, as shown in Fig. 33 and Fig. 34, in the array substrate, the distance between the pixel electrode PE and the slit SL includes at least two unequal distances at the same side of the slit SL. Fig. 33 and Fig. 34 show a distance W5 and a distance W6, and the distance W5 and the distance W6 are not equal.

For example, as shown in Fig. 33 and Fig. 34, the array substrate further includes an electrode lead CEL, the electrode lead CEL is connected with the common electrode CE, and the orthographic projection of the electrode lead CEL on the base substrate 101 overlaps with the orthographic projection of the data line DL on the base substrate 101.

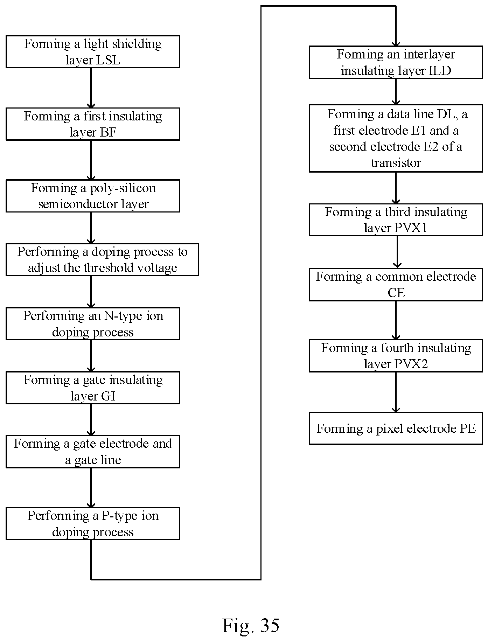

Fig. 35 is a manufacturing flow chart of an array substrate provided by an embodiment of the present disclosure. As shown in Fig. 35 and the cross-sectional views and plan views given by the embodiment of the present disclosure, the manufacturing method of the array substrate includes the following steps.

Step (1): forming a light shielding layer LSL.

Step (2): forming a first insulating layer BF.

Step (3): forming a poly-silicon semiconductor layer.

Step (4): performing a doping process to adjust the threshold voltage.

Step (5): performing an N-type ion doping process.

Step (6): forming a gate insulating layer GI.

Step (7): forming a gate electrode and a gate line.

Step (8): performing a P-type ion doping process.

Step (9): forming an interlayer insulating layer ILD.

Step (10): forming a data line DL, a first electrode E1 and a second electrode E2 of a transistor.

Step (11): forming a third insulating layer PVX1.

Step (12): forming a common electrode CE.

Step (13): forming a fourth insulating layer PVX2.

Step (14): forming a pixel electrode PE.

Of course, the manufacturing method of the array substrate provided by the embodiment of the present disclosure is not limited to the above method. It can be made by other suitable methods. The manufacturing method of the array substrate and the formation sequence of each film layer can be determined according to its structure.

Table 1 shows the material and thickness of each film layer in an array substrate provided by an embodiment of the present disclosure. Of course, the material and thickness of each film layer in the array substrate are not limited to those shown in the table.

**Table 1. Material and Thickness of each Film Layer in the Array Substrate**

| Film Layer | Material | Thickness (Å) |
|---|---|---|
| Light shielding Layer LS | Mo | 800 |
| First Insulating Layer BF | SiOₓ | 3600 |
| Active Layer AT | Si | 700 |
| Gate Insulating Layer GI | SiOₓ | 1100 |
| Gate Electrode GT | Mo | 3000 |
| Interlayer Insulating Layer ILD | SiNₓ/SiOₓ | 1800/6000 |
| Data Line DT, Second Electrode E2 | Ti/Al//Ti | 3500 |
| Third Insulating Layer PVX1 | SiNₓ/SiOₓ | 1600/3600 |
| Common Electrode CE | ITO | 900 |
| Fourth Insulating Layer PVX2 | SiNₓ | 800 |
| Pixel Electrode PE | ITO | 900 |

An embodiment of the present disclosure further provides a display device, which includes any of the above array substrates.

For example, the display device includes a liquid crystal display device. For example, the display device includes a liquid crystal display screen or a product including the liquid crystal display screen. For example, the display device includes any product or component having display function and containing the above-mentioned array substrate, such as glasses, televisions, digital cameras, mobile phones, watches, tablet computers, notebook computers, navigators, etc.
(1) Unless otherwise defined, in the embodiment of the present disclosure and the accompanying drawings, the same reference numeral represents the same meaning.
(2) In the accompanying drawings of the embodiments of the present disclosure, only the structures related to the embodiments of the present disclosure are involved, and other structures can refer to the common design.
(3) For the sake of clarity, in the accompanying drawings used to describe the embodiments of the present disclosure, the thickness of a layer or a region is scaled up. It can be understood that when an element such as a layer, film, region or substrate is referred to as being "on" or "under" another element, the element may be "directly" on or "under" the another element, or an intervening element may be present. When an element is referred to as being in contact with another element, there is no intervening element between the two elements.
(4) In case of no conflict, features in the same embodiment and different embodiments of the present disclosure can be combined with each other.
(5) "First," "second," and similar words used in the present disclosure do not indicate any order, quantity or importance, but are only used to distinguish different components. Ordinal numbers before components can also be removed or replaced, so that they can be arranged according to the order of appearance.

The above are only specific embodiments of the present disclosure, but the protection scope of the present disclosure is not limited thereto. Any person familiar with this technical field can easily think of changes or substitutions within the technical scope disclosed in the present disclosure, which should be covered by the protection scope of the present disclosure. Therefore, the protection scope of the present disclosure should be based on the protection scope of the claims.

## Claims

1. An array substrate, comprising:
a base substrate, comprising a main surface;
a transistor, located on the main surface of the base substrate, and comprising an active layer and a first electrode connected with the active layer;
a first insulating layer, located between the base substrate and the active layer;
a second insulating layer, located between the active layer and the first electrode;
a pixel electrode, connected with the first electrode; and
a common electrode, insulated from the pixel electrode, the pixel electrode and the common electrode being configured to form an electric field,
wherein the first electrode is in contact with a surface of the active layer facing away from the base substrate, and is in contact with a side surface of the active layer.

2. The array substrate according to claim 1, further comprising a first via hole, wherein the first electrode is connected with the active layer through the first via hole, and the first via hole comprises a first through hole penetrating the second insulating layer and a first groove located in the first insulating layer.

3. The array substrate according to claim 2, wherein a maximum dimension of the first groove in a plane parallel with the main surface is less than a minimum dimension of the first through hole in the plane parallel with the main surface.

4. The array substrate according to claim 2 or 3, wherein a maximum dimension of the first groove in a direction perpendicular to the main surface is less than a maximum dimension of the first through hole in the direction perpendicular to the main surface.

5. The array substrate according to any one of claims 2-4, wherein the pixel electrode extends into the first via hole and is in contact with the first electrode at the first via hole.

6. The array substrate according to claim 5, wherein the pixel electrode and the first electrode are conformal at the first via hole, and a maximum dimension of a portion, in contact with the first electrode, of the pixel electrode in a direction perpendicular to the main surface is greater than or equal to a maximum dimension of the first via hole in the direction perpendicular to the main surface.

7. The array substrate according to claim 5 or 6, further comprising: a third insulating layer, wherein the third insulating layer is located on the first electrode, and the common electrode is located on the third insulating layer.

8. The array substrate according to claim 7, wherein the pixel electrode and the common electrode are conformal at the first via hole.

9. The array substrate according to any one of claims 2-8, wherein the first insulating layer comprises a first insulating portion and a second insulating portion, the first groove is located in the first insulating portion, and a thickness of the first insulating portion is greater than a thickness of the second insulating portion.

10. The array substrate according to claim 9, wherein the thickness of the first insulating portion is greater than twice the thickness of the second insulating portion.

11. The array substrate according to claim 9 or 10, further comprising a light shielding layer, wherein the light shielding layer is located between the active layer and the base substrate, an orthographic projection of the active layer on the base substrate falls within an orthographic projection of the light shielding layer on the base substrate, and the first electrode and the light shielding layer form a compensation capacitor.

12. The array substrate according to claim 11, wherein the light shielding layer is floating or the light shielding layer is electrically connected with the common electrode.

13. The array substrate according to any one of claims 1-10, further comprising a light shielding layer, wherein the light shielding layer is located between the active layer and the base substrate, an orthographic projection of the active layer on the base substrate falls within an orthographic projection of the light shielding layer on the base substrate, and the first electrode and the light shielding layer form a compensation capacitor.

14. The array substrate according to claim 13, wherein the light shielding layer is floating or the light shielding layer is electrically connected with the common electrode.

15. The array substrate according to claim 13 or 14, wherein a thickness of the first insulating layer is in a range from 50nm to 300nm.

16. The array substrate according to any one of claims 11-15, wherein the pixel electrode and the common electrode form a main storage capacitor, and a ratio of a capacitance of the compensation capacitor to a capacitance of the main storage capacitor is greater than or equal to 0.2.

17. The array substrate according to claim 16, wherein the ratio of the capacitance of the compensation capacitor to the capacitance of the main storage capacitor is less than or equal to 0.8.

18. The array substrate according to claim 17, wherein the ratio of the capacitance of the compensation capacitor to the capacitance of the main storage capacitor is greater than or equal to 0.25 and less than or equal to 0.6.

19. The array substrate according to any one of claims 1-15, wherein at least one of the first electrode and the pixel electrode forms a first storage capacitor with the common electrode, and the first storage capacitor comprises a first capacitor in a plane parallel with the main surface and a second capacitor in a direction perpendicular to the main surface.

20. The array substrate according to claim 19, wherein the pixel electrode and the common electrode form a main storage capacitor, and a ratio of a capacitance of the second capacitor to a capacitance of the main storage capacitor is greater than or equal to 0.02.

21. The array substrate according to claim 20, wherein the ratio of the capacitance of the second capacitor to the capacitance of the main storage capacitor is less than or equal to 0.2.

22. The array substrate according to claim 21, wherein the ratio of the capacitance of the second capacitor to the capacitance of the main storage capacitor is greater than or equal to 0.06 and less than or equal to 0.08.

23. The array substrate according to any one of claims 19-22, further comprising a third insulating layer and a fourth insulating layer, wherein the third insulating layer is located on the first electrode, the common electrode is located on the third insulating layer, and the fourth insulating layer is located between the pixel electrode and the common electrode.

24. The array substrate according to claim 23, further comprising a second via hole, wherein the pixel electrode is connected with the first electrode through the second via hole, the second via hole comprises a second through hole and a second groove, the second through hole penetrates the third insulating layer or penetrates the fourth insulating layer and the third insulating layer, and the second groove is located in the second insulating layer; and the pixel electrode is in contact with a surface of the first electrode facing away from the base substrate, and is in contact with a side surface of the first electrode.

25. The array substrate according to claim 24, wherein a maximum dimension of the second groove in a plane parallel with the main surface is less than a minimum dimension of the second through hole in the plane parallel with the main surface.

26. The array substrate according to claim 24 or 25, wherein a maximum dimension of the second groove in a direction perpendicular to the main surface is less than a maximum dimension of the second through hole in the direction perpendicular to the main surface.

27. The array substrate according to any one of claims 19-22, wherein the common electrode is located between the first electrode and the pixel electrode, the common electrode and the first electrode form one first storage capacitor, and the common electrode and the pixel electrode form another first storage capacitor.

28. The array substrate according to claim 27, further comprising a third insulating layer, a fourth insulating layer, and a second via hole, wherein the third insulating layer is located on the first electrode, the fourth insulating layer is located between the pixel electrode and the common electrode, the pixel electrode is connected with the first electrode through the second via hole, and the second via hole comprises a second through hole and a second groove, the second through hole penetrates the third insulating layer or penetrates the third insulating layer and the fourth insulating layer, and the second groove is located in the second insulating layer.

29. The array substrate according to claim 28, wherein the pixel electrode is in contact with a surface of the first electrode facing away from the base substrate, and is in contact with a side surface of the first electrode.

30. The array substrate according to claim 28 or 29, further comprising a first via hole, wherein the first electrode is connected with the active layer through the first via hole, the pixel electrode is in contact with a surface of the first electrode facing away from the base substrate, and an orthographic projection of the first via hole on the base substrate overlaps with an orthographic projection of the second via hole on the base substrate.

31. The array substrate according to claim 30, wherein the first via hole comprises a first through hole penetrating the second insulating layer and a first groove located in the first insulating layer.

32. The array substrate according to any one of claims 2-31, further comprising a data line, wherein the transistor further comprises a second electrode, the second electrode is connected with the active layer, the data line is connected with the second electrode, and an orthographic projection of the pixel electrode on the base substrate overlaps with an orthographic projection of the data line on the base substrate.

33. The array substrate according to claim 32, wherein a width of a portion of the pixel electrode overlapping with the data line is less than 3 microns.

34. The array substrate according to any one of claims 2-31, further comprising a data line, wherein the transistor further comprises a second electrode, the second electrode is connected with the active layer, the data line is connected with the second electrode, one of the pixel electrode and the common electrode which is away from the base substrate has a slit, and an orthographic projection of the common electrode on the substrate overlaps with an orthographic projection of the data line on the base substrate.

35. The array substrate according to claim 34, wherein a width of a portion of the common electrode overlapping with the data line is less than 3 microns.

36. The array substrate according to claim 34 or 35, wherein an included angle between the data line and the slit is in a range from 1 degree to 20 degrees.

37. The array substrate according to any one of claims 2-12, wherein a shape of the first via hole comprises at least one of a circle, a rectangle, or a chamfered rectangle.

38. The array substrate according to any one of claims 2-12, further comprising a first protection structure, wherein an orthographic projection of the first protection structure on the base substrate overlaps with an orthographic projection of the first via hole on the base substrate, a portion of the first protection structure is filled in a first recess of the array substrate at the first via hole, and a portion of the first protection structure protrudes from the first recess.

39. The array substrate according to any one of claims 24-26 and 28-31, further comprising a second protection structure, wherein an orthographic projection of the second protection structure on the base substrate overlaps with an orthographic projection of the second via hole on the base substrate, a portion of the second protection structure is filled in a second recess of the array substrate at the second via hole, and a portion of the second protection structure protrudes from the second recess.

40. The array substrate according to any one of claims 2-12, further comprising a data line, wherein the transistor further comprises a second electrode, the second electrode is connected with the active layer, the data line is connected with the second electrode, the pixel electrode is located between the common electrode and the base substrate, and the common electrode has a slit.

41. The array substrate according to claim 40, wherein a distance between the pixel electrode and the slit comprises at least two unequal distances at a same side of the slit.

42. The array substrate according to claim 41, further comprising an electrode lead, wherein the electrode lead is connected with the common electrode, and an orthographic projection of the electrode lead on the base substrate overlaps with an orthographic projection of the data line on the base substrate.

43. The array substrate according to any one of claims 40-42, wherein the data line comprises a plurality of inclined portions, a bending portion is arranged between adjacent inclined portions, an extension direction of the inclined portion is the same as an extension direction of the slit, and the first via hole has a chamfer, and an extension direction of an edge of the first via hole at the chamfer is the same as an extension direction of the bending portion.

44. The array substrate according to claim 43, wherein a distance between the edge of the first via hole at the chamfer and the bending portion is greater than or equal to 1 micron and less than or equal to 5 microns.

45. The array substrate according to any one of claims 40-44, wherein the pixel electrode has a first portion and a second portion with different extension directions, an extension direction of the first portion is the same as an extension direction of the slit, and an edge of the first portion is parallel with an edge of the slit, and is parallel with an edge of the data line.

46. The array substrate according to claim 45, wherein an edge of the second portion is not parallel with the edge of the slit, and the edge of the second portion is parallel with the data line.

47. The array substrate according to claim 46, wherein a minimum distance between the edge of the second portion and the edge of the slit is less than 1 micron.

48. An array substrate comprising:
a base substrate, comprising a main surface;
a transistor, located on the main surface of the base substrate, and comprising an active layer and a first electrode connected with the active layer;
a first insulating layer, located between the base substrate and the active layer;
a second insulating layer, located between the active layer and the first electrode; and
a pixel electrode, connected with the first electrode,
wherein the pixel electrode is in contact with a surface of the first electrode facing away from the base substrate, and is in contact with a side surface of the first electrode.

49. The array substrate according to claim 48, further comprising:
a third insulating layer, located on the first electrode; and
a common electrode, located on the third insulating layer, and insulated from the pixel electrode, the pixel electrode and the common electrode being configured to form an electric field,
wherein the pixel electrode and the common electrode form a main storage capacitor.

50. The array substrate according to claim 49, further comprising a fourth insulating layer, wherein the fourth insulating layer is located between the pixel electrode and the common electrode.

51. The array substrate according to claim 50, further comprising a second via hole, wherein the pixel electrode is connected with the first electrode through the second via hole, the second via hole comprises a second through hole and a second groove, the second through hole penetrates the third insulating layer or penetrates the fourth insulating layer and the third insulating layer, and the second groove is located in the second insulating layer; and the pixel electrode is in contact with a surface of the first electrode facing away from the base substrate, and is in contact with a side surface of the first electrode.

52. The array substrate according to any one of claims 49-51, further comprising a light shielding layer, wherein the light shielding layer is located between the active layer and the base substrate, an orthographic projection of the active layer on the base substrate falls within an orthographic projection of the light shielding layer on the base substrate, and the first electrode and the light shielding layer form a compensation capacitor.

53. The array substrate according to claim 52, wherein the pixel electrode and the common electrode form a main storage capacitor, and a ratio of a capacitance of the compensation capacitor to a capacitance of the main storage capacitor is greater than or equal to 0.2.

54. The array substrate according to claim 53, wherein the ratio of the capacitance of the compensation capacitor to the capacitance of the main storage capacitor is less than or equal to 0.8.

55. The array substrate according to any one of claims 49-54, wherein at least one of the first electrode and the pixel electrode forms a first storage capacitor with the common electrode, and the first storage capacitor comprises a first capacitor in a plane parallel with the main surface and a second capacitor in a direction perpendicular to the main surface.

56. The array substrate according to claim 55, wherein the pixel electrode and the common electrode form a main storage capacitor, and a ratio of a capacitance of the second capacitor to a capacitance of the main storage capacitor is greater than or equal to 0.02.

57. The array substrate according to claim 56, wherein the ratio of the capacitance of the second capacitor to the capacitance of the main storage capacitor is less than or equal to 0.2.

58. The array substrate according to claim 57, wherein the ratio of the capacitance of the second capacitor to the capacitance of the main storage capacitor is greater than or equal to 0.06 and less than or equal to 0.08.

59. A display device, comprising the array substrate according to any one of claims 1-58.
